# EUROPEAN PATENT APPLICATION

(11) **EP 1 740 019 A1**
(43) Date of publication of application: **03.01.2007**
(21) Application number: 05728489.5
(22) Date of filing: 07.04.2005
(51) Int. Cl.: H05B 33/14, C09K 11/06, H05B 33/22

(54) **ORGANIC ELECTROLUMINESCENT DEVICE**

(30) Priority: 19.04.2004 JP 2004123104
(71) Applicant: IDEMITSU KOSAN CO., LTD., Tokyo 100-8321 (JP)
(72) Inventor: FUNAHASHI, Masakazu, 2990293 (JP)
(74) Representative: Gille Hrabal Struck Neidlein Prop Roos
(86) International application number: PCT/JP2005/006849
(87) International publication number: WO 2005/104627

(57) **Abstract**

An organic electroluminescent (EL) device of the present invention, comprising a pair of electrodes and at least an organic compound layer comprising a layer or a plural layer including a light emitting layer interposed between the pair of electrodes, wherein the organic light emitting layer (1) contains at least a compound selected from the silacyclopentadiene derivatives having specific structure and at least a compound selected from the borane derivatives having specific structure, and at least a compound selected from the compounds containing amine, or the organic light emitting layer (2) contains at least a compound selected from the silacyclopentadiene derivatives having specific structure, and at least a compound selected from the compounds containing amine. Thereby, the organic EL device has excellent heat resistance and a long lifetime, and exhibits high current efficiency, and also emits a color in the range of from blue to red.

## Description

### TECHNICAL FIELD

The present invention relates to an organic electroluminescent ("electroluminescent" will be occasionally referred to as "EL", hereinafter) device, in particular, to an organic electroluminescent device having excellent heat resistance and a long lifetime and exhibiting high current efficiency, and also emitting a light in the range of from blue to red.

### BACKGROUND ART

An organic electroluminescent device is a spontaneous light emitting device which utilizes the principle that a fluorescent substance emits light by energy of recombination of holes injected from an anode and electrons injected from a cathode when an electric field is applied. Since an organic EL device of the laminate type driven under a low electric voltage was reported by C. W. Tang et al. of Eastman Kodak Company (C. W. Tang and S. A. Vanslyke, Applied Physics Letters, Volume 51, Pages 913, 1987), many studies have been conducted on organic EL devices using organic materials as the constituting materials.
Tang et al. used a laminate structure using tris(8-quinolinol) aluminum for the light emitting layer and a triphenyldiamine derivative for the hole transporting layer.
Advantages of the laminate structure are that the efficiency of hole injection into the light emitting layer can be increased, that the efficiency of forming excited particles which are formed by blocking and recombining electrons injected from the cathode can be increased, and that excited particles formed among the light emitting layer can be enclosed.
As the structure of the organic EL device, a two-layered structure having a hole transporting (injecting) layer and an electron transporting and light emitting layer and a three-layered structure having a hole transporting (injecting) layer, a light emitting layer and an electron transporting (injecting) layer are well known. To increase the efficiency of recombination of injected holes and electrons in the devices of the laminate type, the structure of the device and the process for forming the device have been studied.
As the light emitting material of the organic EL device, chelate complexes such as tris(8-quinolinol)aluminum complex, coumarin derivatives, tetraphenylbutadiene derivatives, bisstyrylarylene derivatives and oxadiazole derivatives are known. It is reported that light in the visible region ranging from blue light to red light can be obtained by using these light emitting materials, and development of a device exhibiting color images is expected (refer to, for example, Patent literatures 1, 2 and 3). However, the materials exhibited insufficient current efficiency and a lifetime which were off from practical use level.

Recently, for example, devices employing silole derivatives were disclosed in Patent literature 4 to 6. Devices employing boron derivatives disclosed were in Patent literature 7, however, an adequate emission luminance for practical application was not achieved. Devices employing aminoanthracene derivatives as the material for emitting a green light were disclosed in Patent literature 8.
However, the heat resistance of organic EL devices employed the materials was low due to the low glass transition temperature thereof, so that a device exhibiting a long lifetime and high current efficiency was not obtained.
Devices, having the light emitting layer comprising a naphthacene derivative or a pentacene derivative and emitting a red light, were disclosed in Patent literature 9. Although the light emitting device emitted a red light with excellent purity, the impressed voltage was as high as 11 V, therefore the half-lifetime of the luminance was only 1500 hours and come short.
Devices, having the light emitting layer comprising amine based-aromatic compounds and emitting a red light, were disclosed in Patent literature 10. Although the devices exhibited the color purity of CIE chromaticity (0.64, 0.33), the driving voltage was as high as 10V or more.
Devices, having the light emitting layer comprising the azafluoranthene compound, were disclosed in Patent literature 11. However, it emitted a light in the range of from yellow to green, but could not emit a red light adequately.
[Patent literature 1] Japanese Patent Application Laid-Open No. Heisei 8(1996)-239655
[Patent literature 2] Japanese Patent Application Laid-Open No. Heisei 7(1995)-138561
[Patent literature 3] Japanese Patent Application Laid-Open No. Heisei 3(1991)-200289
[Patent literature 4] Japanese Patent Application Laid-Open No. Heisei 9(1997)-87616
[Patent literature 5] Japanese Patent Application Laid-Open No. Heisei 9(1997)-194487
[Patent literature 6]: International PCT publication No. WO 00/02886
[Patent literature 7]: International PCT publication No. WO 00/040586
[Patent literature 8] Japanese Patent Application Laid-Open No. 2001-207167
[Patent literature 9] Japanese Patent Application Laid-Open No. 08(1996)-311442
[Patent literature 10] Japanese Patent Application Laid-Open No. 2001-81451
[Patent literature 11] Japanese Patent Application Laid-Open No. 2001-160489

The present invention has been made to overcome the above problems and has an objective of providing an organic electroluminescent device having excellent heat resistance and a long lifetime, exhibiting high current, efficiency, and emitting a light in the range of from blue to red.

As a result of intensive researches and studies to achieve the above objective, the present inventors found that employing at least one selected from silacyclopentadiene derivatives having specific structure and borane derivatives having specific structure, and at least one selected from compounds containing amine, in an organic light emitting layer enables to achieve the above objective and the present invention was made.
Namely, the present invention provides organic EL devices of the following (1) and (2):
(1) an organic EL device comprising a pair of electrodes and at least an organic compound layer comprising a layer or a plural layer including a light emitting layer interposed between the pair of electrodes, wherein the organic light emitting layer contains at least a compound selected from silacyclopentadiene derivatives represented by the following general formula (I) and a compound selected from the borane derivatives represented by the following general formula (II), and a compound selected from the compounds containing amine.

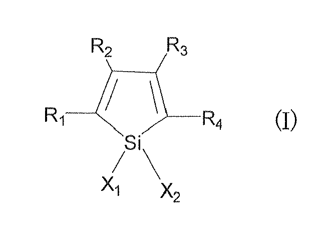

wherein, X₁ and X₂ each independently represents an alkyl group having carbon atoms of 1 to 6, which may have substituent, an alkenyl group having carbon atoms of 1 to 6, which may have substituent, an alkynyl group having carbon atoms of 1 to 6, an alkoxy group having carbon atoms of 1 to 6, which may have substituent, an alkenyloxy having carbon atoms of 1 to 6, which may have substituent, an alkynyloxy group having carbon atoms of 1 to 6, a hydroxy group, an aryl group having carbon atoms of 5 to 50, which may have substituent, or a hetero ring group having carbon atoms of 3 to 50, and also X₁ and X₂ may bond to form a saturated or unsaturated ring.
R₁ to R₄ each independently represents a hydrogen atom, a halogen atom, an alkyl group having carbon atoms of 1 to 6, which may have substituent, an alkenyl group having carbon atoms of 1 to 6, which may have substituent, an alkynyl group having carbon atoms of 1 to 6, which may have substituent, an alkoxy group having carbon atoms of 1 to 6, which may have substituent, an alkenyloxy group having carbon atoms of 1 to 6, which may have substituent, an alkynyloxy group having carbon atoms of 1 to 6, which may have substituent, an aryl group having carbon atoms of 5 to 50, which may have substituent, a hetero ring group having carbon atoms of 3 to 50, which may have substituent, an aryloxy group having carbon atoms of 5 to 50, which may have substituent, an amino group, an alkylcarbonyl group having carbon atoms of 1 to 7, which may have substituent, an arylcarbonyl group having carbon atoms of 5 to 50, which may have substituent, an alkoxycarbonyl group having carbon atoms of 1 to 7, which may have substituent, an aryloxycarbonyl group having carbon atoms of 5 to 50, which may have substituent, an alkylcarbonyloxy group having carbon atoms of 1 to 7, which may have substituent, an aryloxycarbonyloxy group having carbon atoms of 5 to 50, which may have substituent, an alkoxycarbonyloxy group having carbon atoms of 1 to 7, which may have substituent, an aryloxycarbonyloxy group having carbon atoms of 5 to 50, which may have substituent, a sulfinyl group, which may have substituent, a sulfonyl group, a sulfanyl group, a silyl group, which may have substituent, a carbamoyl group, which may have substituent, a hydroxy group, a nitro group, a formyl group, a nitroso group, a formyloxy group, an isocyano group, a cyanate group, an isocyanate group, a thiocyanate group, an isothiocyanate group or a cyano group, and neighboring groups thereof may bond each other to form a saturated or unsaturated ring.

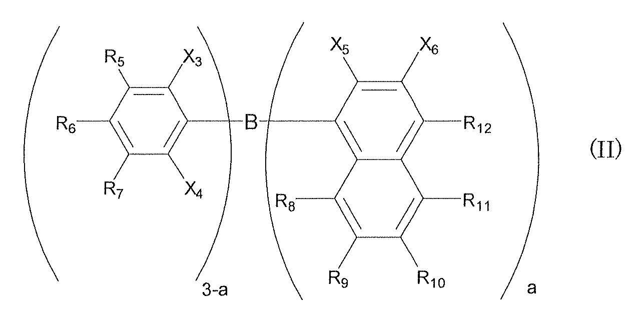

wherein, R₅ to R₁₂ and X₆ each independently represents a hydrogen atom, an alkyl group having carbon atoms of 1 to 6, which may have substituent, an alkenyl group having carbon atoms of 1 to 6, which may have substituent, an alkynyl group having carbon atoms of 1 to 6, which may have substituent, an aryl group having carbon atoms of 5 to 50, which may have substituent, a hetero ring group having carbon atoms of 3 to 50, which may have substituent, a substituted amino group, a substituted boryl group, an alkoxy group having carbon atoms of 1 to 6, which may have substituent, or an aryloxy group having carbon atoms of 5 to 50, which may have substituent.
wherein, X₃ to X₅ each independently represents an alkyl group having carbon atoms of 1 to 6, which may have substituent, an alkenyl group having carbon atoms of 1 to 6, which may have substituent, an alkynyl group having carbon atoms of 1 to 6, which may have substituent, an aryl group having carbon atoms of 5 to 50, which may have substituent, a hetero ring group having carbon atoms of 3 to 50, which may have substituent, a substituted amino group, a silyl group, which may have substituent, a substituted boryl group, an alkoxy group having carbon atoms of 1 to 6, which may have substituent, or an aryloxy group having carbon atoms of 5 to 50, which may have substituent.
In addition, X₅ and X₆ may bond each other to form a saturated or unsaturated ring. a represents an integer of 1 to 3.

(2) an organic EL device comprising a pair of electrodes and at least an organic compound layer comprising a layer or a plural layer including a light emitting layer, interposed between the pair of electrodes, wherein the light emitting layer contains at least a compound selected from the silacyclopentadiene derivatives represented by the following general formula (III), and at least a compound selected from the compounds containing amine.

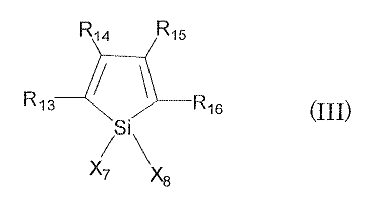

wherein, X₇ and X₈ each independently represents an alkyl group having carbon atoms of 1 to 6, which may have substituent, an alkenyl group having carbon atoms of 1 to 6, which may have substituent, an alkynyl group having carbon atoms of 1 to 6, an alkoxy group having carbon atoms of 1 to 6, which may have substituent, an alkenyloxy group having carbon atoms of 1 to 6, which may have substituent, an alkynyloxy group having carbon atoms of 1 to 6, a hydroxy group, an aryl group having carbon atoms of 5 to 50, which may have substituent, or a hetero ring group having carbon atoms of 3 to 50, and also X₇ and X₈ may bond to form a saturated ring or an unsaturated ring.
R₁₃ to R₁₆ each independently represents a hydrogen atom, a halogen atom, an alkyl group having carbon atoms of 1 to 6, which may have substituent, an alkenyl group having carbon atoms of 1 to 6, which may have substituent, an alkynyl group having carbon atoms of 1 to 6, which may have substituent, an alkoxy group having carbon atoms of 1 to 6, which may have substituent, an alkenyloxy group having carbon atoms of 1 to 6, which may have substituent, an alkynyloxy group having carbon atoms of 1 to 6, which may have substituent, an aryl group having carbon atoms of 5 to 50, which may have substituent, an aryloxy group having carbon atoms of 5 to 50, which may have substituent, an amino group, an alkylcarbonyl group having carbon atoms of 1 to 7, which may have substituent, an arylcarbonyl group having carbon atoms of 5 to 50, which may have substituent, an alkoxycarbonyl group having carbon atoms of 1 to 7, which may have substituent, an aryloxycarbony group having carbon atoms of 5 to 50, which may have substituent, an alkylcarbonyloxy group having carbon atoms of 1 to 7, which may have substituent, an arylcarbonyloxy group having carbon atoms of 5 to 50, which may have substituent, an alkoxycarbonyloxy group having carbon atoms of 1 to 7, which may have substituent, aryloxycarbonyloxy having carbon atoms of 5 to 50, which may have substituent, a sulfinyl group, which may have substituent, a sulfonyl group, a sulfanyl group, a silyl group, which may have substituent, a carbamoyl group, which may have substituent, a hydroxy group, a nitro group, a formyl group, a nitroso group, a formyloxy group, an isocyano group, a cyanate group, an isocyanate group, a thiocyanate group, an isothiocyanate group or a cyano group, and neighboring groups thereof may bond each other to form a saturated or unsaturated ring.

The organic EL device of the present invention has excellent heat resistance and a long lifetime, and exhibits high current efficiency, and also emits a light in the range of from blue to red.

### THE PREFERRED EMBODIMENT TO CARRY OUT THE INVENTION

The organic EL device of the present invention is explained in details as follows;
The organic EL device of the present invention provides an organic EL device comprising a pair of electrodes consisting of an anode and a cathode, and an organic compound layer comprising a layer or a plural layer including a light emitting layer interposed between the pair of electrodes consisting of an anode and a cathode, wherein the organic light emitting layer contains : (1) at least a compound selected from the silacyclopentadiene derivatives represented by the following general formula (I) and the borane derivatives represented by the following general formula (II), and at least a compound selected from compounds containing amine, or (2) at least a compound selected from the silacyclopentadiene derivatives represented by the following general formula (III), and at least a compound selected from compounds containing amine. The general formulae (I) to (III) are explained as follows:

Firstly, the silacyclopentadiene represented by the general formula (I) is as follows:

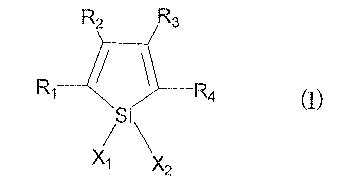

In the general formula (I), X₁ and X₂ each independently represents an alkyl group having carbon atoms of 1 to 6, which may have substituent, such as a methyl group, an ethyl group, a n-propyl group, an isopropyl group, a cyclopentyl group, and a tert-butyl group, an alkenyl group having carbon atoms of 1 to 6, which may have substituent, such as a vinyl group, an allyl group, a butenyl group, and a styryl group, an alkynyl group having carbon atoms of 1 to 6, which may have substituent, such as an ethynyl group, a propargyl group, and a phenylacetyl group, an alkoxy group having carbon atoms of 1 to 6, which may have substituent, such as a methoxy group, an ethoxy group, an isopropoxy group, and a tert-butoxy group, an alkenyloxy group having carbon atoms of 1 to 6, which may have substituent, such as a vinyloxy group, and an allyloxy group, an alkynyloxy group having carbon atoms of 1 to 6, which may have substituent, such as an ethynyloxy group and a phenylacetyloxy group, a hydroxy group, an aryl group having carbon atoms of 5 to 50, which may have substituent, such as a phenyl group, a naphthyl group, an anthracenyl group, a biphenyl group, a tolyl group, a pyrenyl group, a perylenyl group, an anisyl group, a terphenyl group, and a phenanthrenyl group, a hetero ring group having carbon atoms of 3 to 50, which may have substituent, such as a hydrofuryl group, a hydropyrenyl group, a dioxanyl group, a thienyl group, a furyl group, an oxazolyl group, an oxadiazolyl group, a thiazolyl group, an oxadiazolyl group, an acridinyl group, a quinolyl group, a quinoxaloyl, a phenanthrolyl group, a benzothienyl group, a benzothiazolyl group, an indolyl group, silacyclopentadienyl group, and a pyridyl group.
In addition, X₁ and X₂ may bond each other to form a saturated or unsaturated ring (a spiro ring) such as silacyclopentadiene and the like.

In the general formula (I), R₁ to R₄ each independently represents a hydrogen atom, a halogen atom such as fluorine and chlorine, an alkyl group having carbon atoms of 1 to 6, which may have substituent, such as a methyl group, an ethyl group, a n-propyl group, an isopropyl group, a cyclopentyl group, a tert-butyl group, and a trifluoromethyl group, an alkenyl group having carbon atoms of 1 to 6, which may have substituent, such as a vinyl group, a allyl group, a butenyl group, and a styryl group, group having carbon atoms of 1 to 6, an alkynyl group having carbon atoms of 1 to 6, which may have substituent, such as an ethynyl group, a propargyl group, and a phenylacetyl group, an alkoxy group having carbon atoms of 1 to 6, which may have substituent, such as a methoxy group, an ethoxy group, an isopropoxy group, a tert-butoxy group, a trifluoromethoxy group, and a pentafluoroethoxy group, an alkenyloxy group having carbon atoms of 1 to 6, which may have substituent, such as a vinyloxy group, and an allyloxy group, an alkynyloxy group having carbon atoms of 1 to 6, which may have substituent, such as an ethynyloxy group, and a phenylacetyloxy group, an aryl group having carbon atoms of 5 to 50, which may have substituent, such as a phenyl group, a biphenyl group, a terphenyl group, a naphthyl group, an anthracenyl group, a pyrenyl group, a tolyl group, an anisyl group, a fluorophenyl group, a diphenylaminophenyl group, a dimethylaminophenyl group, diethylaminophenyl group, and a phenanthrenyl group a hetero ring group having carbon atoms of 3 to 50, which may have substituent, such as a thienyl group, a furyl group, a silacyclopentadienyl group, an oxazolyl group, an oxadiazolyl group, a thiazolyl group, a thiadiazolyl group, an acridinyl group, a quinolyl group, a quinoxaloyl group, a phenanthrolyl group, a benzothienyl group, a benzothiazolyl group, an indolyl group, a carbazolyl group, a pyridyl group, a pyrrolyl group, a benzoxazolyl group, a pyrimidyl group, and an imidazolyl group, an aryloxy group having carbon atoms of 5 to 50, which may have substituent, such as a phenoxy group, a naphthoxy group, a biphenyloxy group, and a pyrenyloxy group, an amino group such as a dimethylamino group, a diethylamino group, and a diphenylamino group, an alkylcarbonyl group having carbon atoms of 1 to 7, which may have substituent, such as an acetyl group, an arylcarbonyl group having carbon atoms of 5 to 50, which may have substituent, such as a benzoyl group, an alkoxycarbonyl group having carbon atoms of 1 to 7, which may have substituent, such as a methoxycarbonyl group, and an ethoxycarbonyl group, an aryloxycarbonyl group having carbon atoms of 5 to 50, which may have substituent, such as a phenoxycarbonyl group, an alkylcarbonyloxy group having carbon atoms of 1 to 7, which may have substituent, such as an acetoxy group, an arylcarbonyloxy group having carbon atoms of 5 to 50, which may have substituent, such as a benzoyloxy group, an alkoxycarbonyloxy group having carbon atoms of 1 to 7, which may have substituent, such as a methoxycarbonyloxy group, an ethoxycarbonyloxy group, an aryloxycarbonyloxy group having carbon atoms of 5 to 50, which may have substituent, such as a phenoxycarbonyloxy group, a naphthoxycarbonyloxy group, a biphenyloxycarbonyloxy group, a pyrenyloxycarbonyloxy group, a sulfinyl group, which may have substituent, such as a methylsulfinyl group, a phenylsulfinyl group, a sulfonyl group, a sulfanyl group, a silyl group, which may have substituent, a trimethylsilyl group, a dimethyl-tert-butylsilyl group, a trimethoxysilyl group, and triphenylsilyl group, a carbamoyl group, which may have substituent, a hydroxy group, a nitro group, a formyl group, a nitroso group, a formyloxy group, an isocyano group, a cyanate group, an isocyanate group, a thiocyanate group, an isothiocyanate group or a cyano group, and neighboring groups among R₁ to R₄ may bond each other to form a saturated or unsaturated ring such as benzene, naphthalene, anthracene, benzofluoranthene, and naphthacene.

In addition, substituent for X₁ and X₂, and R₁ to R₄ includes an alkyl group having carbon atoms of 1 to 6, a cycloalkyl group having carbon atoms of 3 to 6, an alkoxyl group having carbon atoms of 1 to 6, an aryloxy group having carbon atoms of 5 to 18, an aralkyloxy group having carbon atoms of 7 to 18, an arylamino group having carbon atoms of 5 to 16, a nitro group, a cyano group, an ester group having carbon atoms of 1 to 6, a halogen atom, and the like.

Next, the silacyclopentadiene derivatives represented by the general formula (III) are explained as follows:

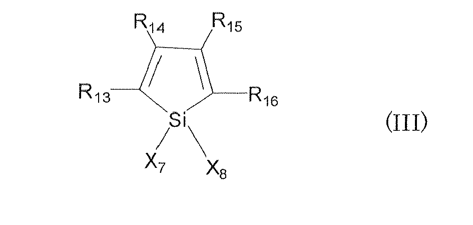

In the general formula (III), X₇ and X₈ each independently represents the same groups mentioned as X₁ and X₂ in the above general formula (I), and examples and the substituent thereof are the same with those mentioned as X₁ and X₂ in the above general formula (I).
In the general formula (III), R₁₃ to R₁₆ each independently represents the same groups excluding the hetero rings mentioned in R₁ to R₄, and examples and the substituent thereof are the same with those mentioned in R₁ to R₄ in the above general formula (I). Examples of the silacyclopentadiene derivatives represented by the aforementioned general formulae (I) and (III) are shown as follows, but not limited thereto. Examples of the general formula (I) among the below-mentioned compounds include (B)-1 to (B)-12, and also examples of the general formula (III) among them include the compounds excluding (B)-9. Here, Me means a methyl group.

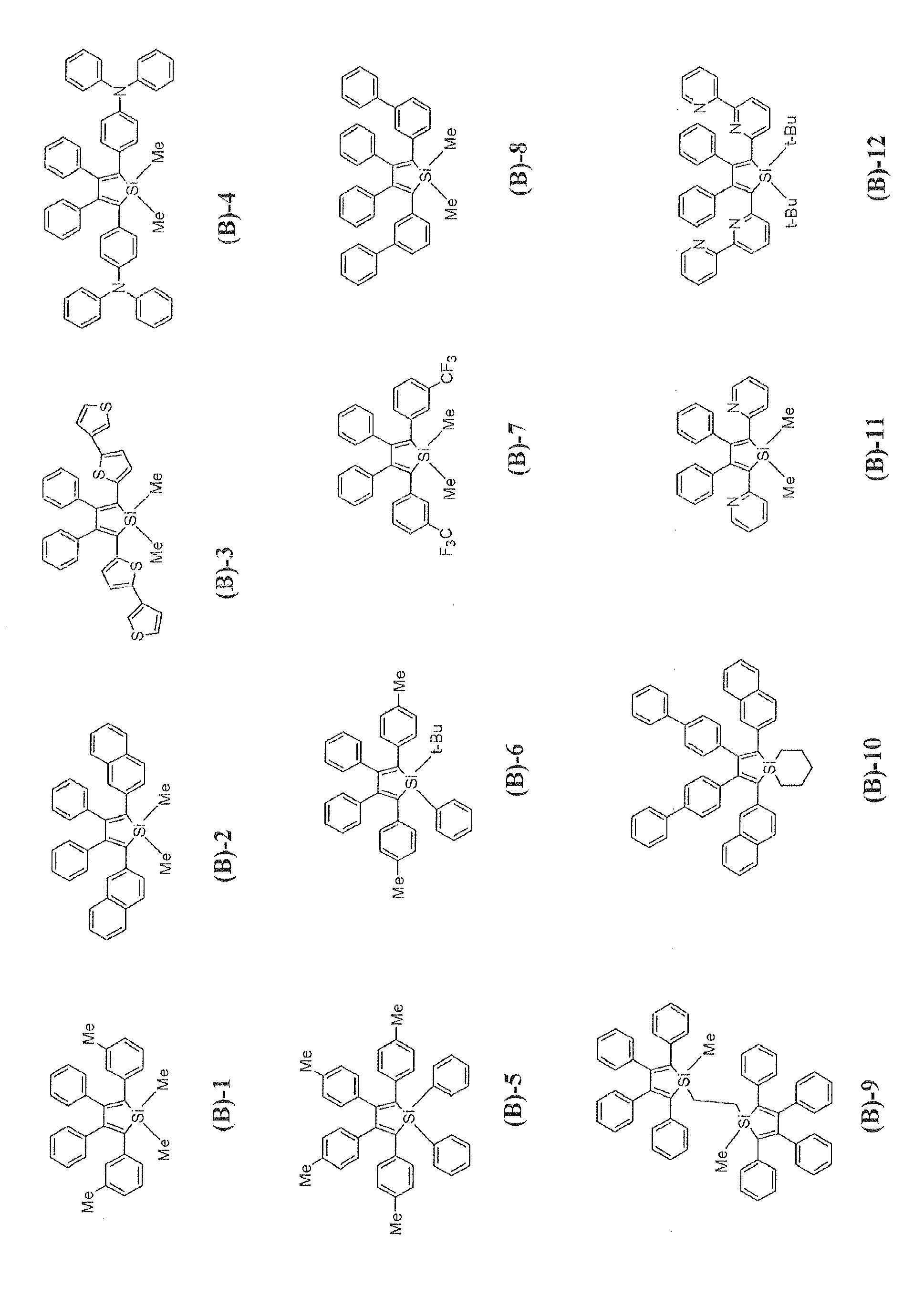

In addition, the borane derivatives represented by the following general formula (II) are explained as follows:

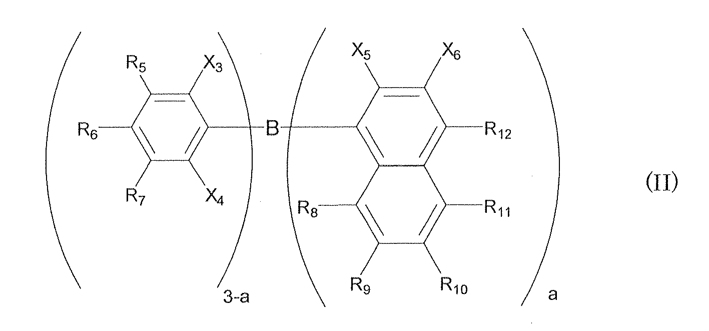

In the general formula (II), R₃ to R₁₂, and X₆ each independently represents a hydrogen atom, an alkyl group having carbon atoms of 1 to 6, which may have substituent, such as a methyl group, an ethyl group, a n-propyl group, an isopropyl group, a cyclopentyl group, and a tert-butyl group, an alkenyl group having carbon atoms of 1 to 6, which may have substituent, such as a vinyl group, an allyl group, a butenyl group, and a styryl group, an alkynyl group having carbon atoms of 1 to 6, which may have substituent, such as an ethynyl group, a propargyl group, and a phenylacetyl group, an aryl group having carbon atoms of 5 to 50, which may have substituent, such as a phenyl group, a naphthyl group, an anthryl group, a biphenyl group, a tolyl group, a pyrenyl group, a perylenyl group, an anisyl group, a terphenyl group, and a phenanthrenyl group, a heteto ring group having carbon atoms of 3 to 50, which may have substituent, such as a hydrofuryl group, a hydropyrenyl group, a dioxanyl group, a thienyl group, a furyl group, a oxazolyl group, a oxadiazolyl group, a thiazolyl group, a thiadiazolyl group, an acridinyl group, a quinolyl group, a quinoxaloyl group, a phenanthrolyl group, a benzothienyl group, a benzothiazolyl group, an indolyl group, a silacyclopentadienyl group, and a pyridyl group, a substituted amino group such as dimethylamino group, and a diphenylamino group, a silyl group, which may have substituent, such as a trimethylsilyl group, a dimethyl-tert-butylsilyl group, a trimethoxysilyl group, and triphenylsilyl group, a substituted boryl group such as a dianthrylboryl group, and dimesitylboryl group, an alkoxy group having carbon atoms of 1 to 6, which may have substituent, such as a methoxy group, an ethoxy group, and a propoxy group, or, an aryloxy group having carbon atoms of 5 to 50, which may have substituent, such as a phenyloxy group.

In the general formula (II), X₃ to X₅ each independently represents an alkyl group having carbon atoms of 1 to 6, which may have substituent, such as a methyl group, an ethyl group, a n-propyl group, an isopropyl group, a cyclopentyl group, and a tert-butyl group, an alkenyl group having carbon atoms of 1 to 6, which may have substituent, such as a vinyl group, an allyl group, a butenyl group, and a styryl group, an alkynyl group having carbon atoms of 1 to 6, which may have substituent, such as an ethynyl group, a propargyl group, and a phenylacetyl group, an aryl group having carbon atoms of 5 to 50, which may have substituent, such as a phenyl group, a naphthyl group, an anthracenyl group, a biphenyl group, a tolyl group, a pyrenyl group, a perylenyl group, an anisyl group, a terphenyl group, and a phenanthrenyl group, a heteto ring group having carbon atoms of 3 to 50, which may have substituent, such as a hydrofuryl group, a hydropyrenyl group, a dioxanyl group, a thienyl group, a furyl group, a oxazolyl group, a oxadiazolyl group, a thiazolyl group, a thiadiazolyl group, an acridinyl group, a quinolyl group, a quinoxaloyl group, a phenanthrolyl group, a benzothienyl group, a benzothiazolyl group, an indolyl group, a silacyclopentadienyl group, and a pyridyl group. a substituted amino group such as a dimethylamino group, and a diphenylamino group, a silyl group, which may have substituent, such as a trimethylsilyl group, a dimethyl-tert-butylsilyl group, a trimethoxysilyl group, and a triphenylsilyl group, a substituted boryl group such as a dianthrylboryl group and a dimesitylboryl group, an alkoxy group having carbon atoms of 1 to 6, which may have substituent, such as a methoxy group, an ethoxy group and a propoxy group, or an aryloxy group having carbon atoms of 5 to 50, which may have substituent, such as a phenyloxy group.

In addition, X₅ and X₆ may bond each other to form a saturated or unsaturated ring such as benzene, naphthalene, anthracene, benzofluoranthene, and naphthacene. a represents an integer of 1 to 3 in the general formula (II). Further, substituent for X₅ and X₆, and R₁₃ to R₁₆ includes an alkyl group having carbon atoms of 1 to 6, a cycloalkyl group having carbon atoms of 3 to 6, an alkoxyl group having carbon atoms of 1 to 6, an aryloxy group having carbon atoms of 5 to 18, an aralkyloxy group having carbon atoms of 7 to 18, an arylamine group having carbon atoms of 5 to 16, a nitro group, a cyano group, an ester group having carbon atoms of 1 to 6, and a halogen atom.
The following is examples of the borane derivatives represented by the aforementioned general formula (II), but not limited thereof.

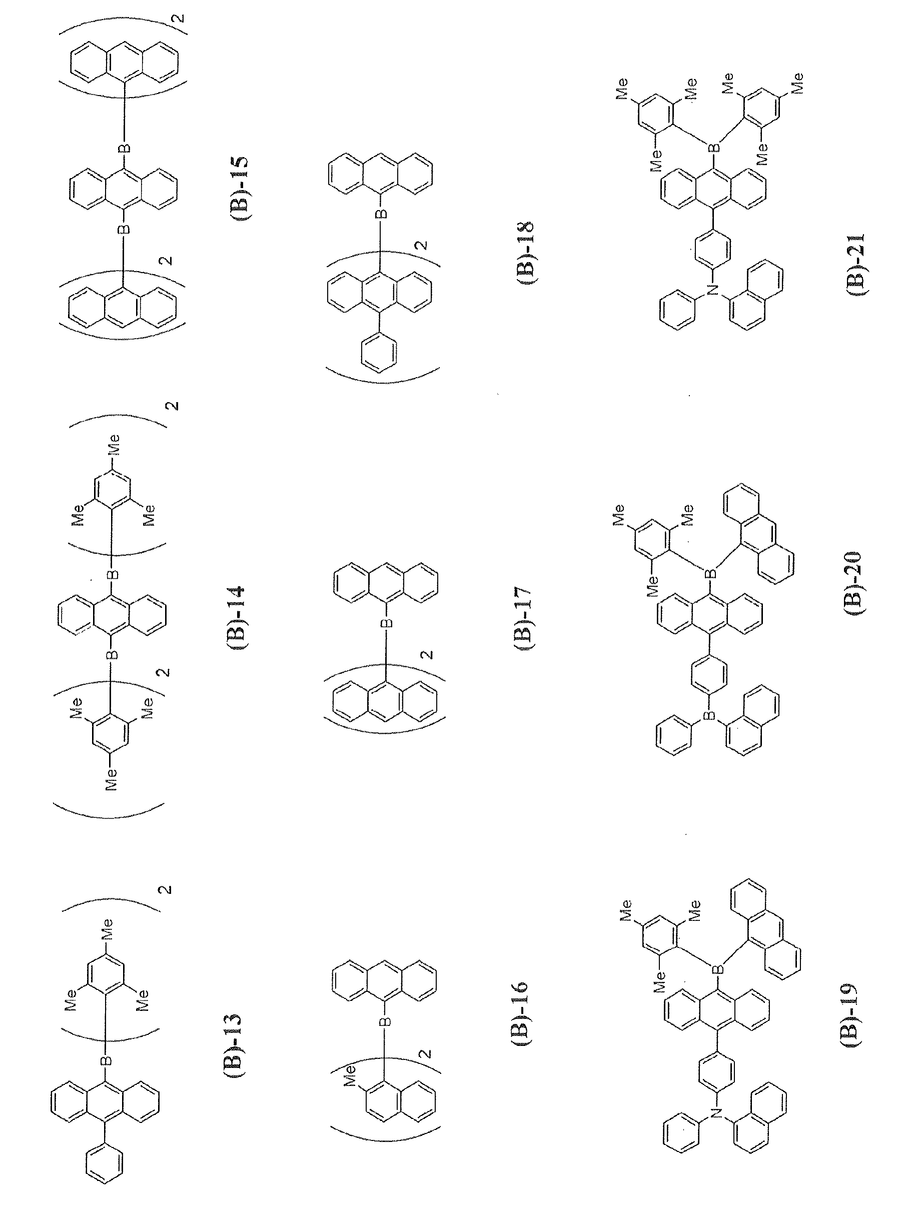

Although compounds containing amine, which is contained in a light emitting layer of the organic EL devices (1) and (2) of the present invention are not limited, the condensed aromatic ring derivatives containing amine represented by the following general formula (IV) are preferable as the compounds containing amine.

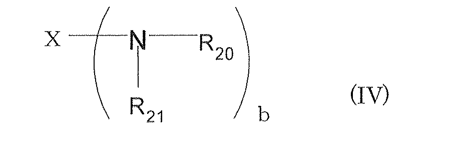

In the general formula (IV), X represents a condensed aromatic ring group having ring carbon atoms of 10 to 40, which may have substituent, R₂₀ and R₂₁ each independently represents a monovalent aryl group having carbon atoms of 6 to 40, which may have substituent, or a monovalent hetero ring group having 3 to 40, which may have substituent, and b represents an integer of 1 to 4.

The condensed aromatic ring group of X represents a moiety of, for example, naphthalene, phenanthrene, fluoranthene, anthracene, pyrene, perylene, coronene, chrysene, picene, diphenylanthracene, fluorene, triphenylene, rubicene, benzanthracene, dibenzanthracene, acenaphthofluoranthene , tribenzopentaphene, fluoranthenofluoranthene, benzodifluoranthene, benzofluoranthene and diindenoperylene, and in particular moieties of pyrene, anthracene, benzofluoranthene, and acenaphthofluoranthene are preferable.
Examples of a monovalent aryl group and a hetero ring group of above R₂₀ and R₂₁ include preferably a phenyl group, a naphthyl group, an anthranyl group, a phenanthryl group, a pyrenyl group, a coronyl group, a biphenyl group, a terphenyl group, a fluorenyl group, a furanyl group, a thienyl group, a benzothienyl group, an indolyl group, a carbazolyl group, a furyl group, a pyrrolyl group, and a pyridyl group, and a phenyl group, a naphthyl group, a pyrenyl group, and a biphenyl group are preferable.

As the condensed aromatic ring derivatives containing amine represented by the general formula (IV), the compounds represented by the general formulae (IV-a) and (TV-a') are preferable.

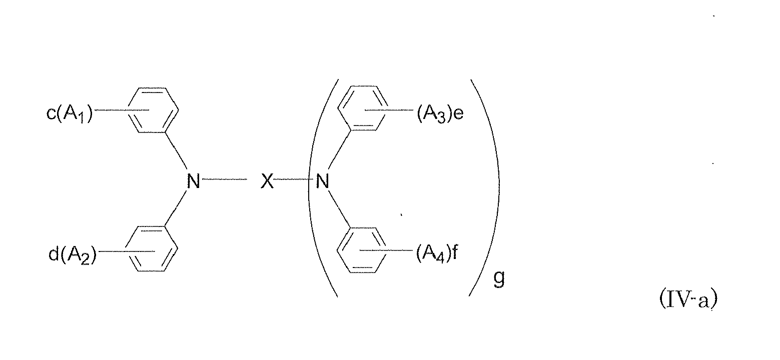

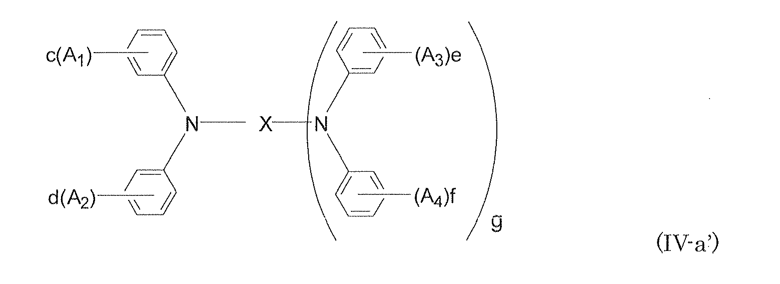

X in the general formulae (IV-a) and (IV-b) represents the same groups with those of aforementioned X.
A₁ to A₄ in the general formulae (IV-a) and (IV-a') each independently represents a hydrogen atom, an alkyl group having carbon atoms of 1 to 50, preferably 1 to 20, which may have substituent, an aryl group having carbon atoms of 5 to 50, preferably 5 to 20, which may have substituent, an aralkyl group having carbon atoms of 7 to 50, preferably 7 to 40, which may have substituent, a cycloalkyl group having ring carbon atoms of 3 to 50, preferably 5 to 12, which may have substituent, an alkoxyl group having carbon atoms of 1 to 50, preferably 1 to 6,which may have substituent, an aryloxyl group having ring carbon atoms of 5 to 50, preferably 5 to 18, which may have substituent, an arylamino group having ring carbon atoms of 5 to 50, preferably 5 to 18, which may have substituent, or an alkylamino group having carbon atoms of 1 to 20, preferably 1 to 6, which may have substituent.

An alkyl group, which may have substituent, of A₁ to A₄ includes, for group, an octyl group, a stearyl group, a 2-phenylisopropyl group, a trichloromethyl group, a trifluoromethyl group, a benzyl group, an α-phenoxybenzyl group, an α,α-dimethylbenzyl group, an α,α-methylphenylbenzyl group, an α,α-ditrifluoromethylbenzyl group, triphenylmethyl group, an α-benzyloxybenzyl group and the like.
An aryl group, which may have substituent, of A₁ to A₄ includes, for example, a phenyl group, a 2-methylphenyl group, a 3-methylphenyl group, a 4-methylphenyl group, a 4-ethylphenyl group, a biphenyl group, a 4-methylbiphenyl group, a 4-ethylbiphenyl group, a 4-cyclohexylbiphenyl group, a terphenyl group, a 3,5-dichlorophenyl group, a naphthyl group, a 5-methylnaphtyl group, an anthryl group, a pyrenyl group and the like.

An aralkyl group, which may have substituent, of Ar to A₄ includes a benzyl group, a 1-phenylethyl group, a 2-phenylethyl group, a 1-phenylisopropyl group, a 2-phenylisopropyl group, a phenyl-t-butyl group, an α-naphthylmethyl group, a 1-α-naphthylethyl group, a 2-α-naphthylethyl group, a 1-α-naphthylisopropyl group, a 2-α-naphthylisopropyl group, a β-naphthylmethyl group, a 1-β-naphthylethyl group, a 2-β-naphthylethyl group, a 1-β-naphthylisopropyl group, a 2-β-naphthylisopropyl group, a 1-pyrrolylmethyl group, a 2-(1-pyrrolyl)ethyl group, a p-methylbenzyl group, a m-methylbenzyl group, an o-methylbenzyl group, a p-chlorobenzyl group, a m-chlorobenzyl group, an o-chlorobenzyl group, a p-bromobenzyl group, a m-bromobenzyl group, an o-bromobenzyl group, a p-iodobenzyl group, a m-iodobenzyl group, an o-iodobenzyl group, a p-hydroxybenzyl group, a m-hydroxybenzyl group, an o-hydroxybenzyl group, a p-aminobenzyl group, a m-aminobenzyl group, an o-aminobenzyl group, a p-nitrobenzyl group, a m-nitrobenzyl group, an o-nitrobenzyl group, a p-cyanobenzyl group, a m-cyanobenzyl group, an o-cyanobenzyl group, a 1-hydroxy-a 2-phenylisopropyl group, a 1-chloro-2-phenylisopropyl group and the like.

A cycloalkyl group, which may have substituent, of A₁ to A₄ includes, for example, a cyclopropyl group, a cyclobutyl group, a cyclopentyl group, a cyclohexyl group and the like. An alkoxyl group, which may have substituent, of A₁ to A₄ includes, for example, a methoxy group, an ethoxy group, a propoxy group, an isopropoxy group, a butoxy group, an isobutoxy group, a sec-butoxy group, a tert-butoxy group, various pentyloxy groups, various hexyloxy groups and the like. An aryloxy group, which may have substituent, of A₁ to A₄ includes, for example, a phenoxy group, a tolyloxy group, a naphthyloxy group and the like. An arylamino group, which may have substituent, of A₁ to A₄ includes, for example, a diphenylamino group, a ditolylamino group, a dinaphthylamino group, a naphthylphenylamino group and the like. An alkylamino group, which may have substituent, includes, for example, a dimethylamino group, a diethylamino group, a dihexylamino group and the like.

c, d, e, and f of the general formulae (IV-a) and (IV-a') each represents an integer of 0 to 5, preferably 0 to 2. When c, d, e, and/or f represent 2 or larger, a plural A₁ to A₄ each may be the same with or different from each other, and also may bond each other to form a saturated or unsaturated ring. g represents an integer of 0 to 4.
However, at least one of A₁ to A₄ in the general formula (IV-a) represents a sec- or tert-alkyl group having carbon atoms of 3 to 10, which may have substituent. A sec- or tert-alkyl group includes sec- or tert-alkyl groups among the aforementioned alkyl groups of A₁ to A₄.
In addition, at least one of c, d, e, and f in the general formula (IV-a') represents an integer of 2 or larger.

An arylamine compound represented by the general formula (IV) includes preferably the arylamine compounds represented by the general formulae (IV-b) and (IV-b') 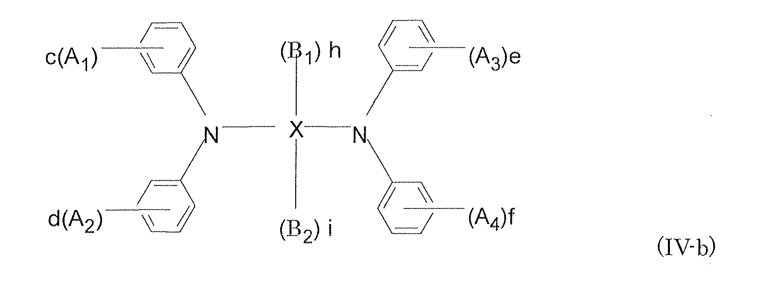 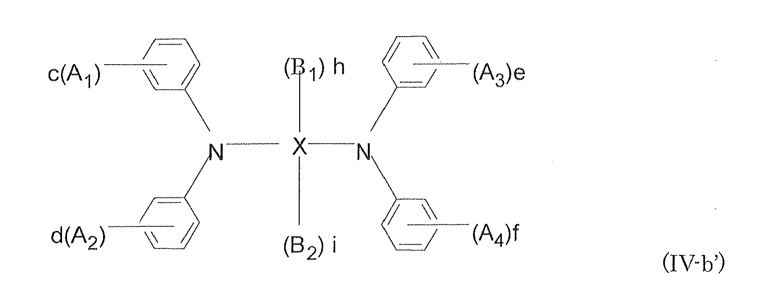 In the general formulae (IV-b) and (IV-b'), X, A₁ to A₄, c, d, e, and f each independently represents the same with those of the general formulae (IV-a) and (IV-a'), and when c, d, e, and/or f represent 2 or larger, a plural A₁ to A₄ each may be the same with or different from each other, and also may bond each other to form a saturated or unsaturated ring.

B₁ and B₂ in the general formulae (IV-b) and (IV-b') each independently represents a hydrogen atom, an alkyl group having carbon atoms of 1 to 10, preferably 1 to 6, which may have substituent, an aryl group having carbon atoms of 6 to 20, preferably 6 to 14, which may have substituent, an aralkyl group having carbon atoms of 7 to 50, preferably 7 to 40, which may have substituent, an alkoxyl group having carbon atoms of 1 to 50, preferably 1 to 6, which may have substituent, an aryloxyl group having ring carbon atoms of 5 to 50, preferably 5 to 18, which may have substituent.
Examples of each group thereof include groups, of which a carbon atom number conforms to those of the aforementioned groups in A₁ to A₄. h and i in the general formula (IV-b) and (IV-b') each represents an integer of 0 to 2.
However, at least one of A₁ to A₄ in the general formula (IV-b) may be a sec-or tert-alkyl group having carbon atoms of 3 to 10, which may have substituent. In addition, in the general formula (IV-b'), at least one of c, d, e, and f may be an integer of 2 or larger.
Substituent in the general formulae (IV), (IV-a), (IV-a'), (IV-b), and (IV-b') includes an alkyl group having carbon atoms of 1 to 6, a cycloalkyl group having carbon atoms of 3 to 6, an alkoxyl group having carbon atoms of 1 to 6, an aryloxy group having carbon atoms of 5 to 18, an aralkyloxy group having carbon atoms of 7 to 18, an arylamino group having carbon atoms of 5 to 16, nitro group, a cyano group, an ester group having carbon atoms of 1 to 6, a halogen atom and the like.

Examples of the condensed ring derivatives containing amine represented by the aforementioned general formula (IV) are as follows, but not limited thereto. Here, Me means a methyl group.

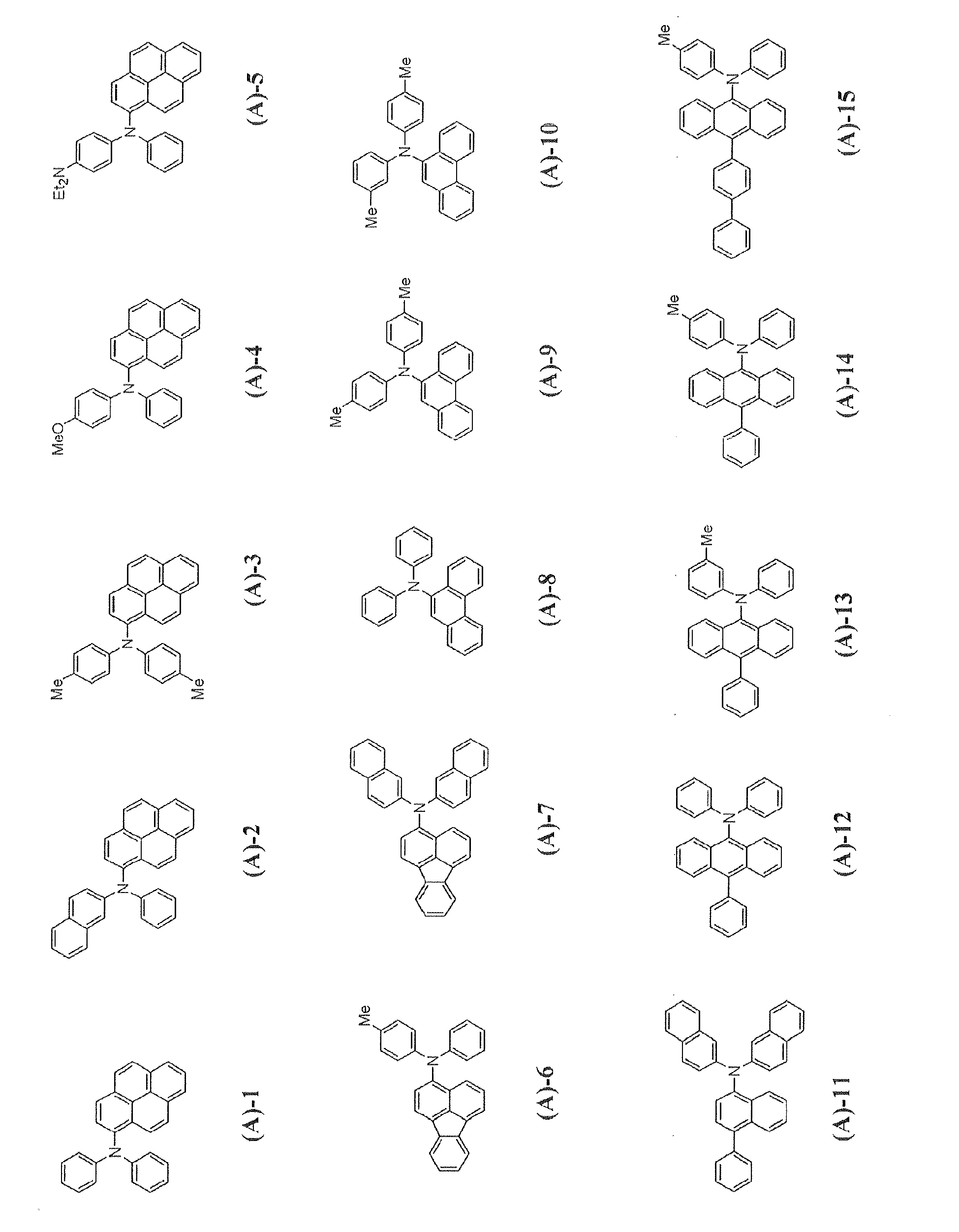

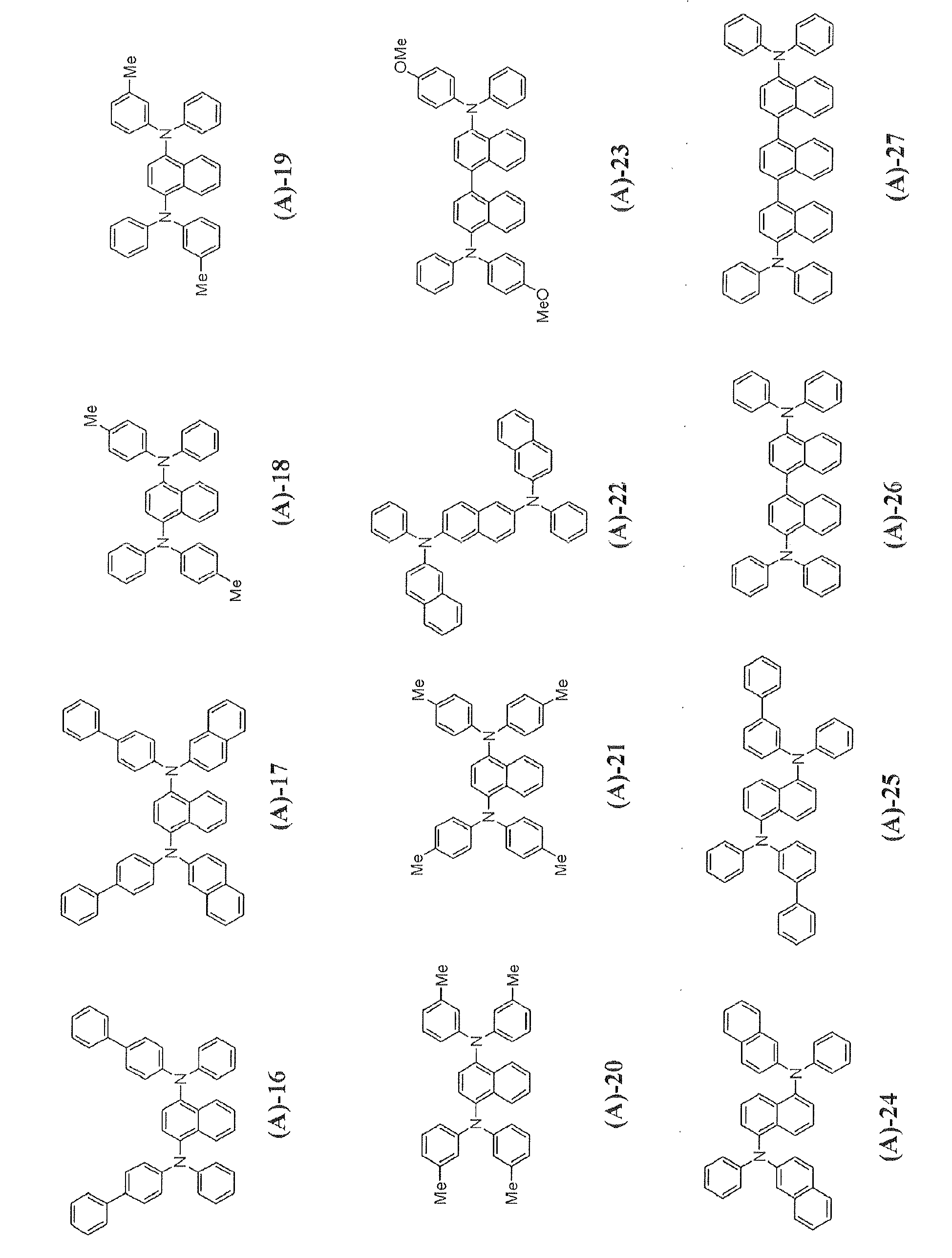

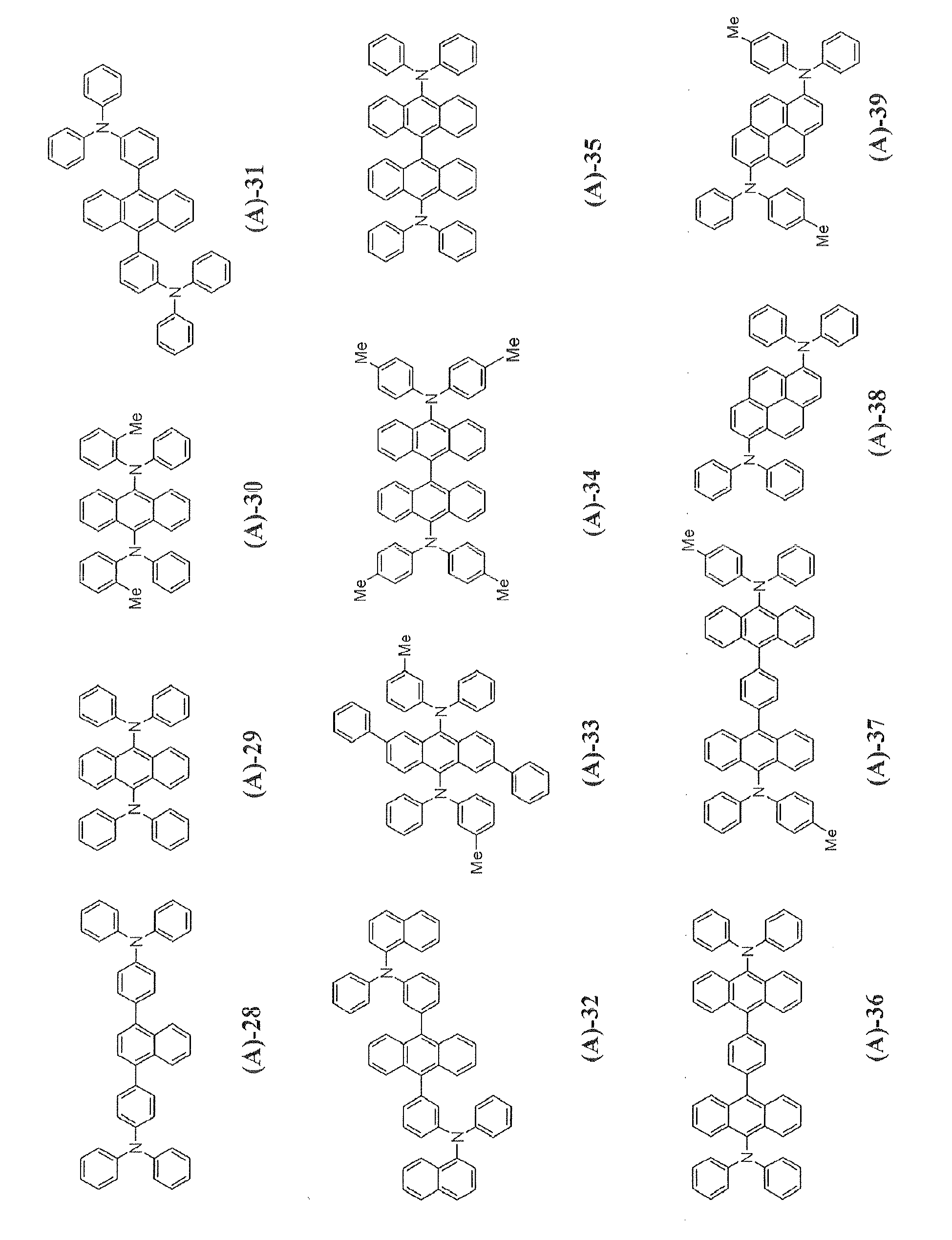

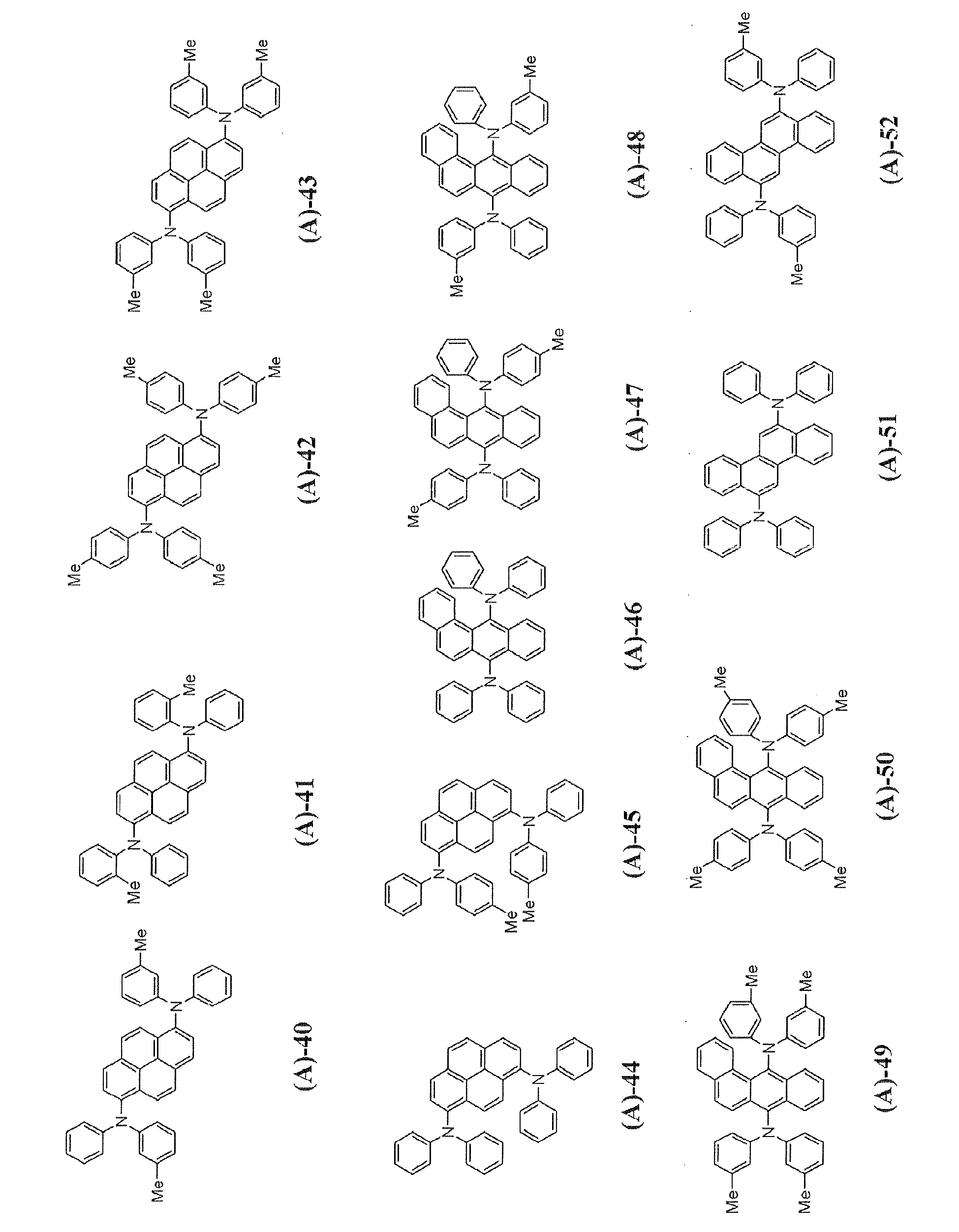

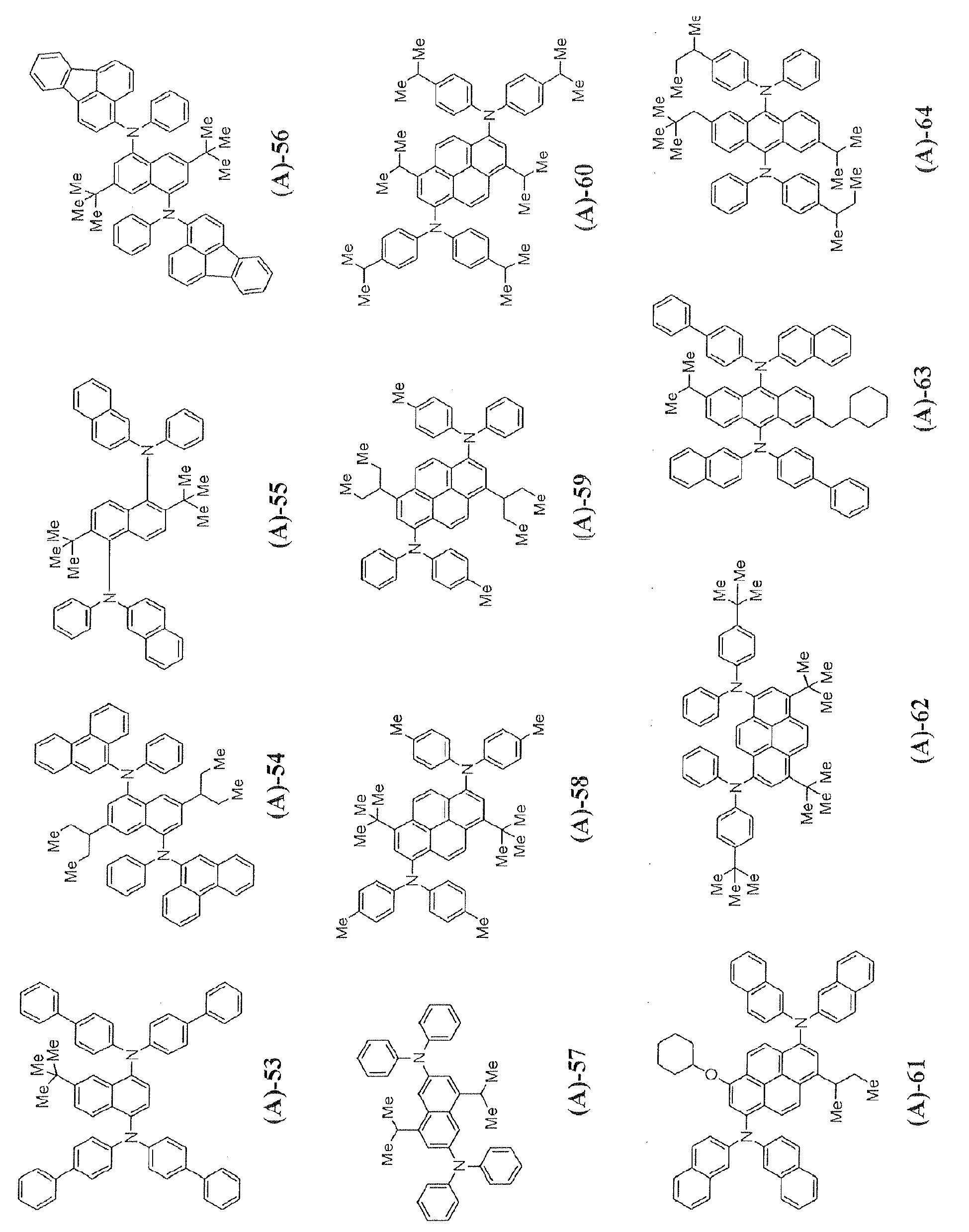

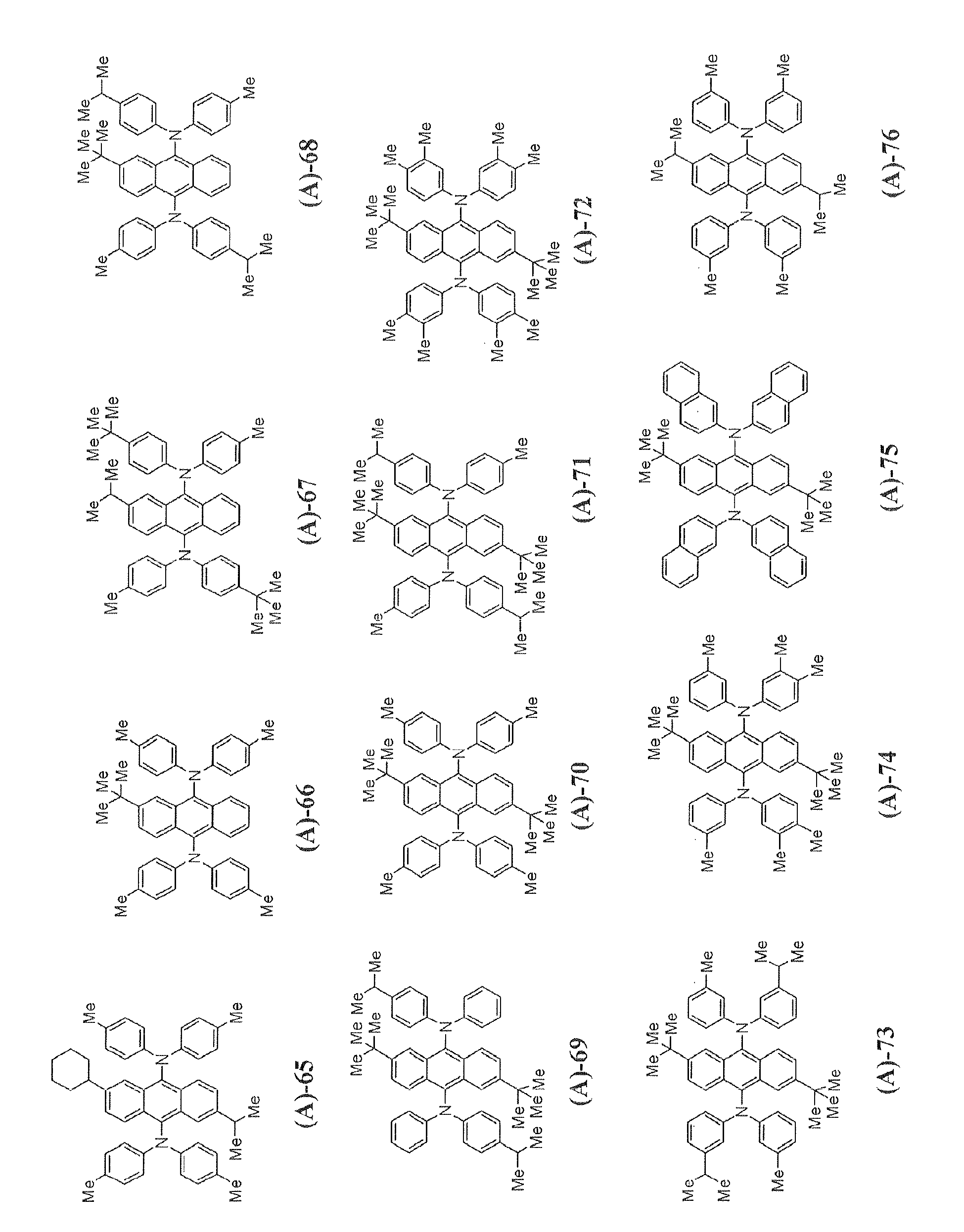

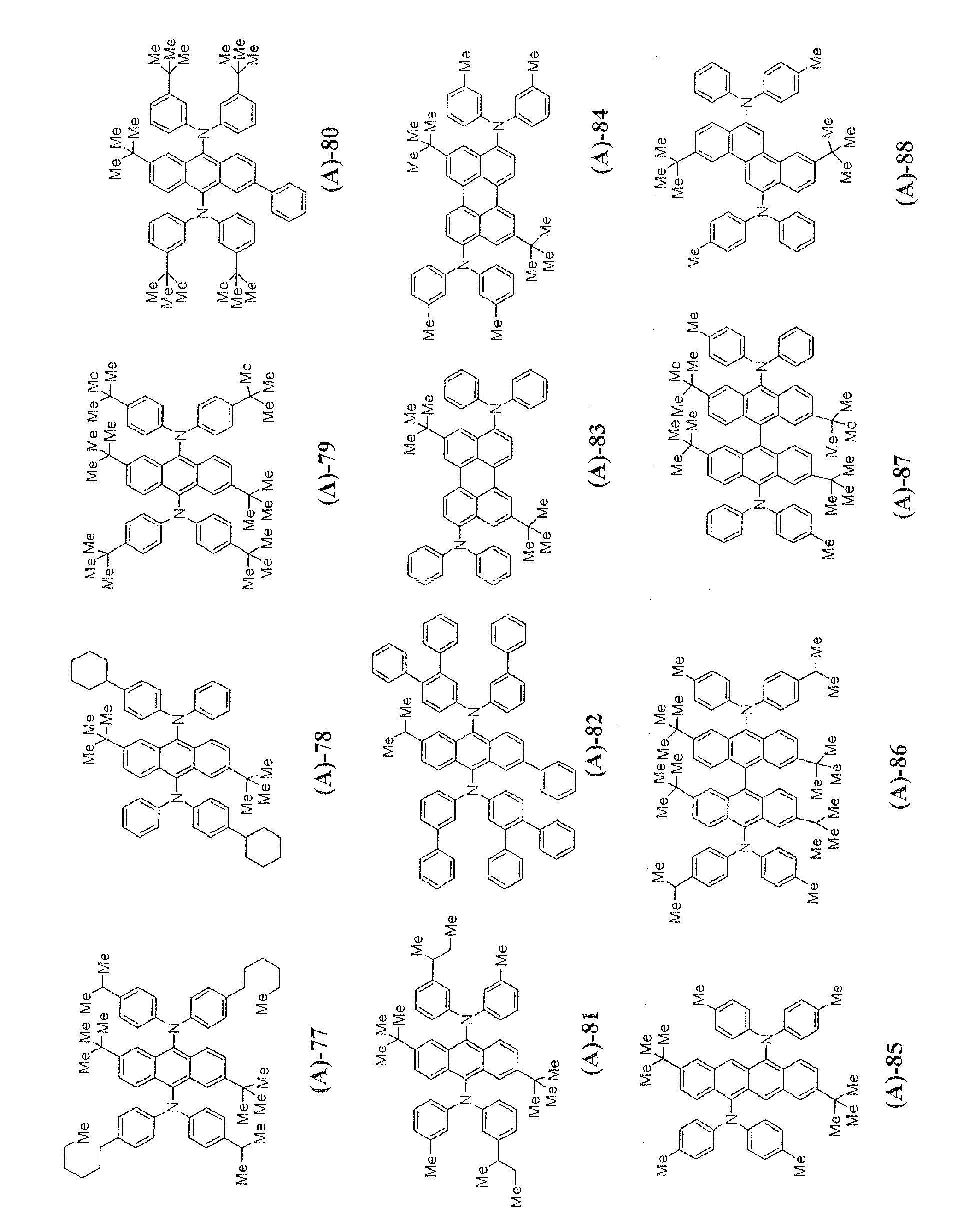

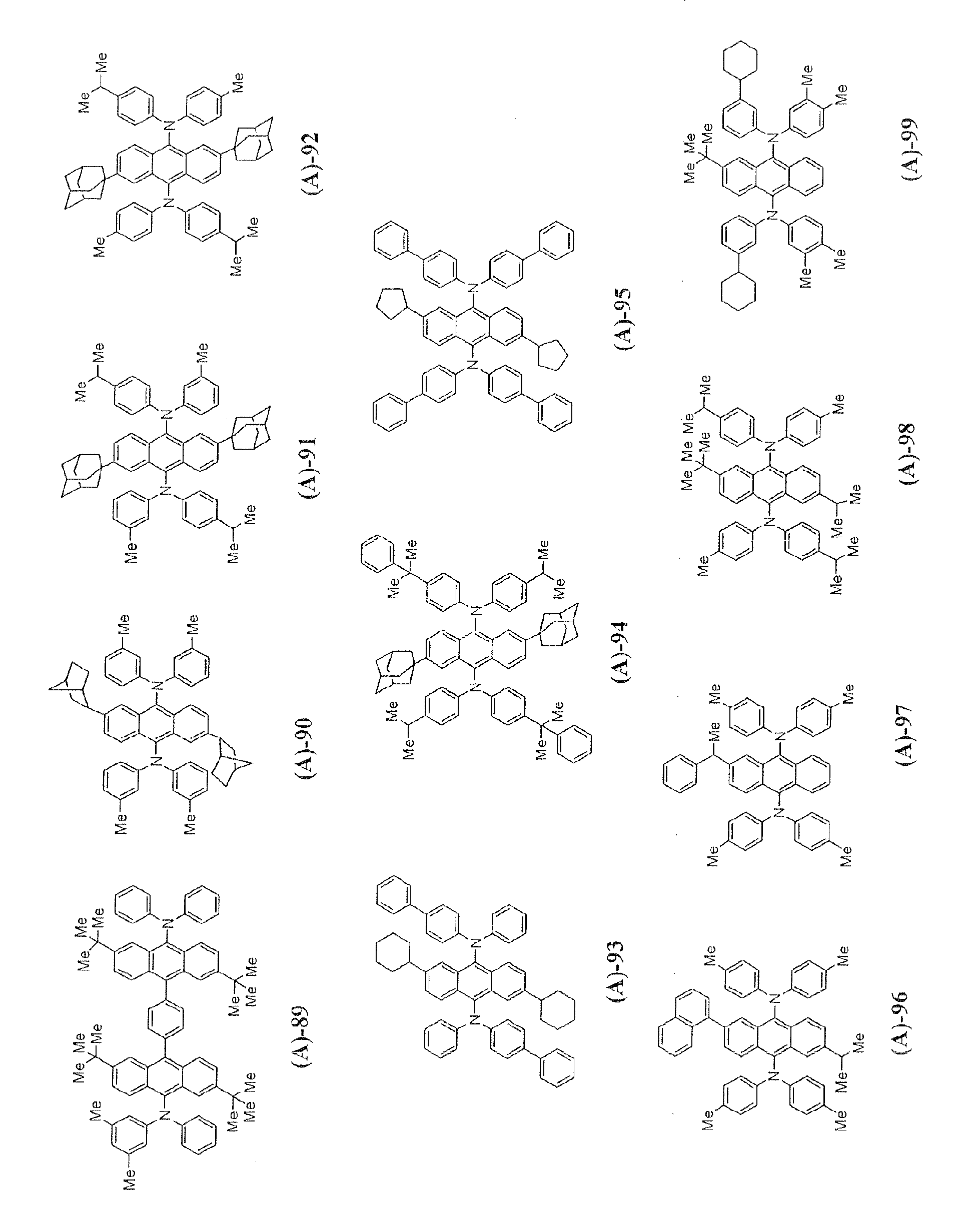

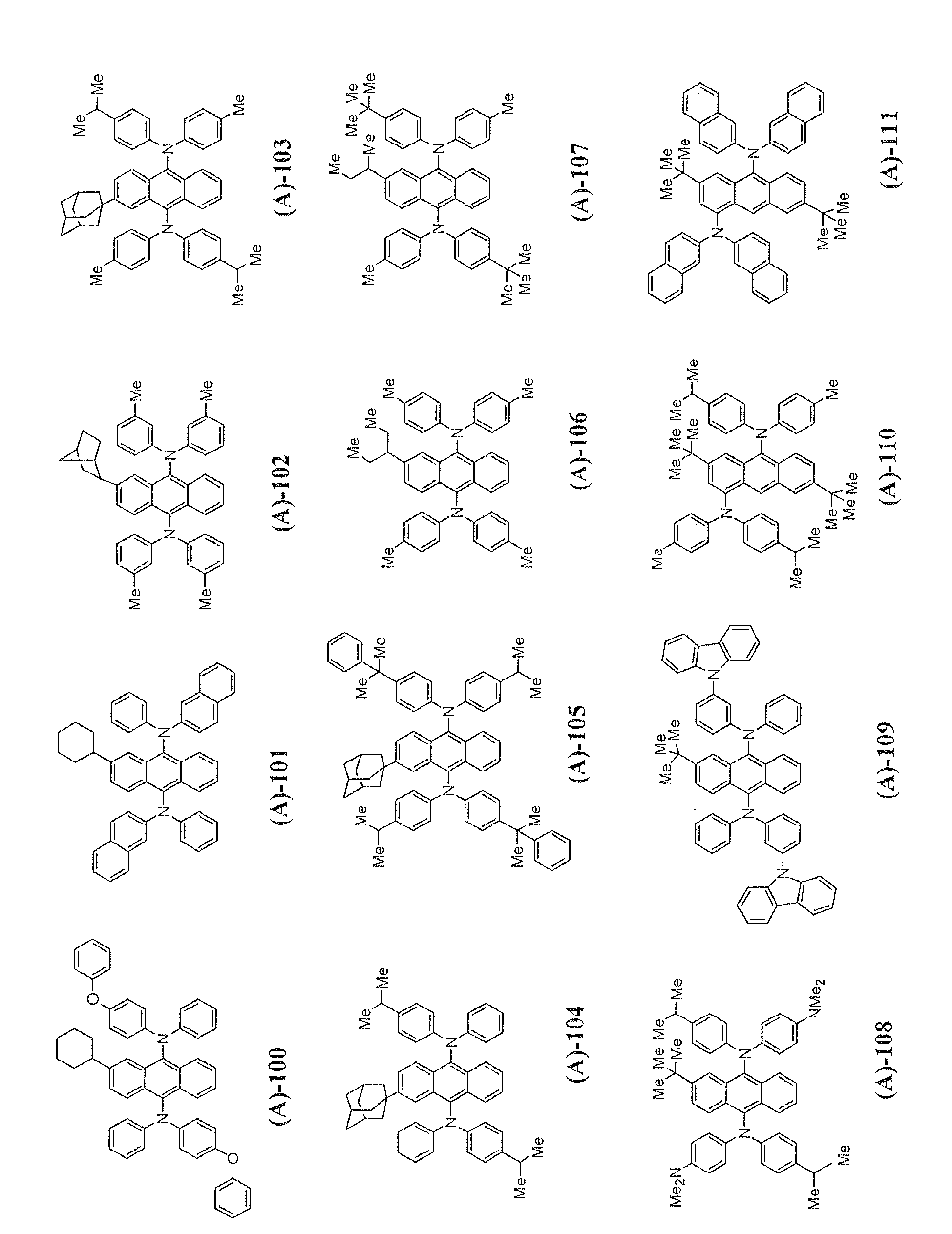

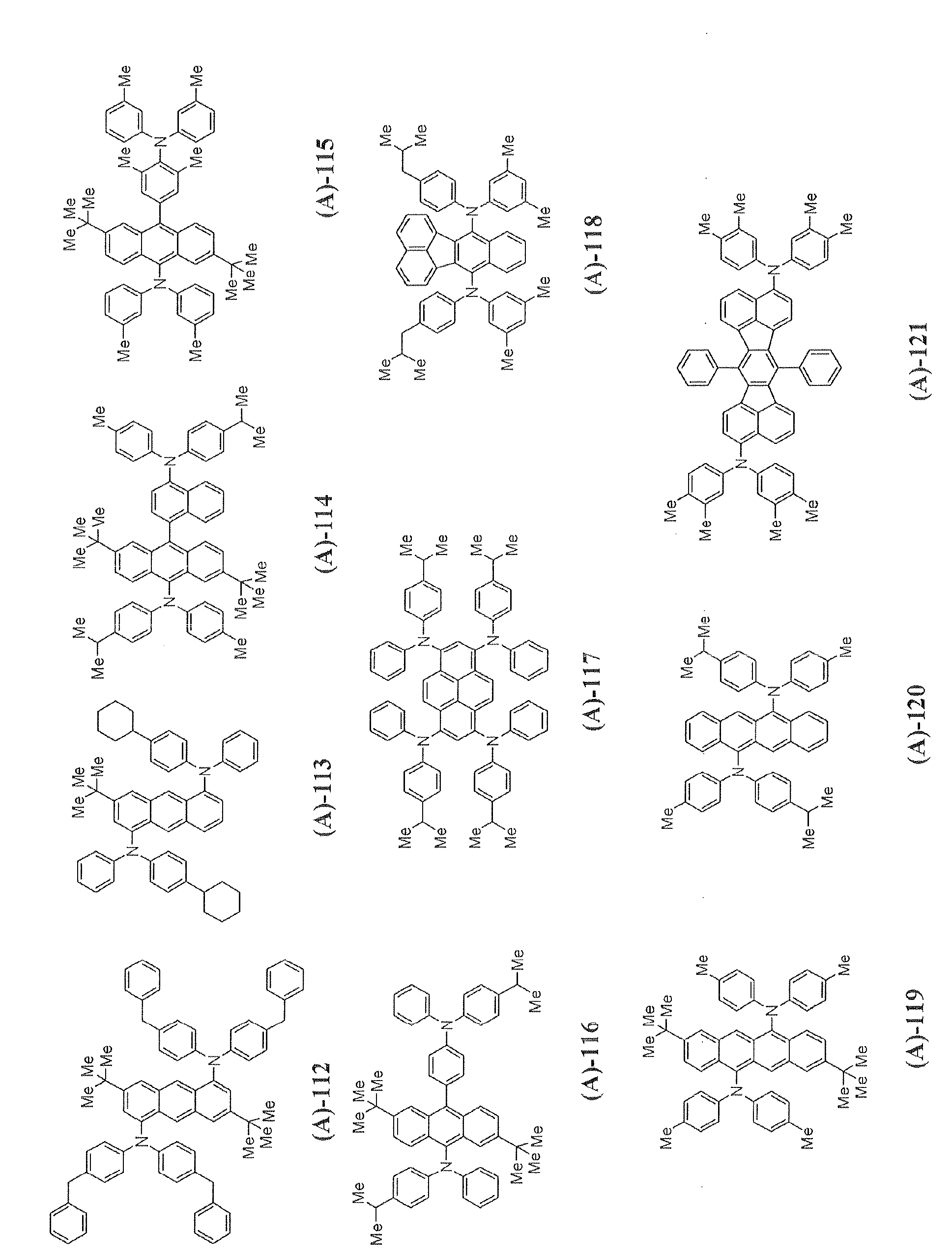

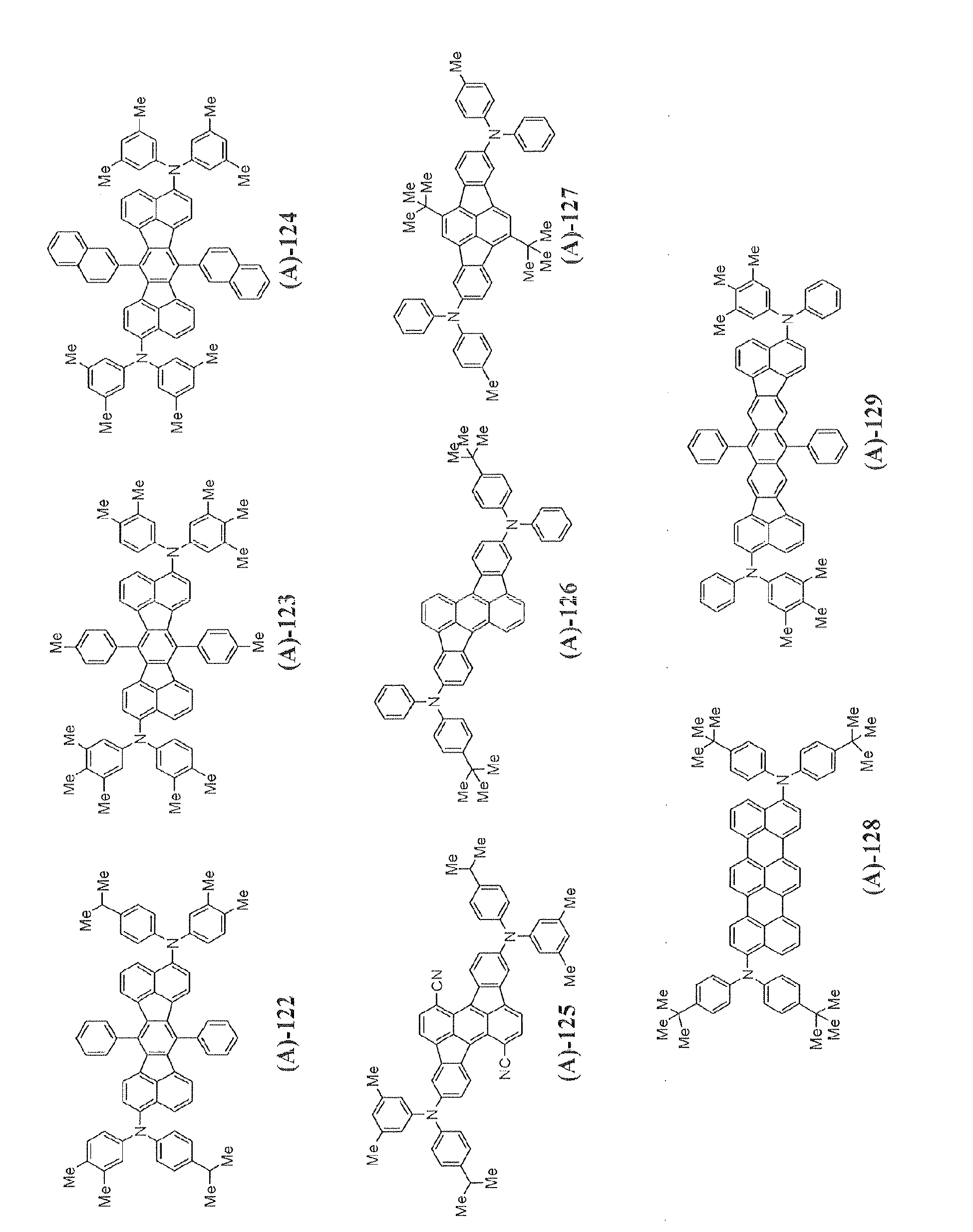

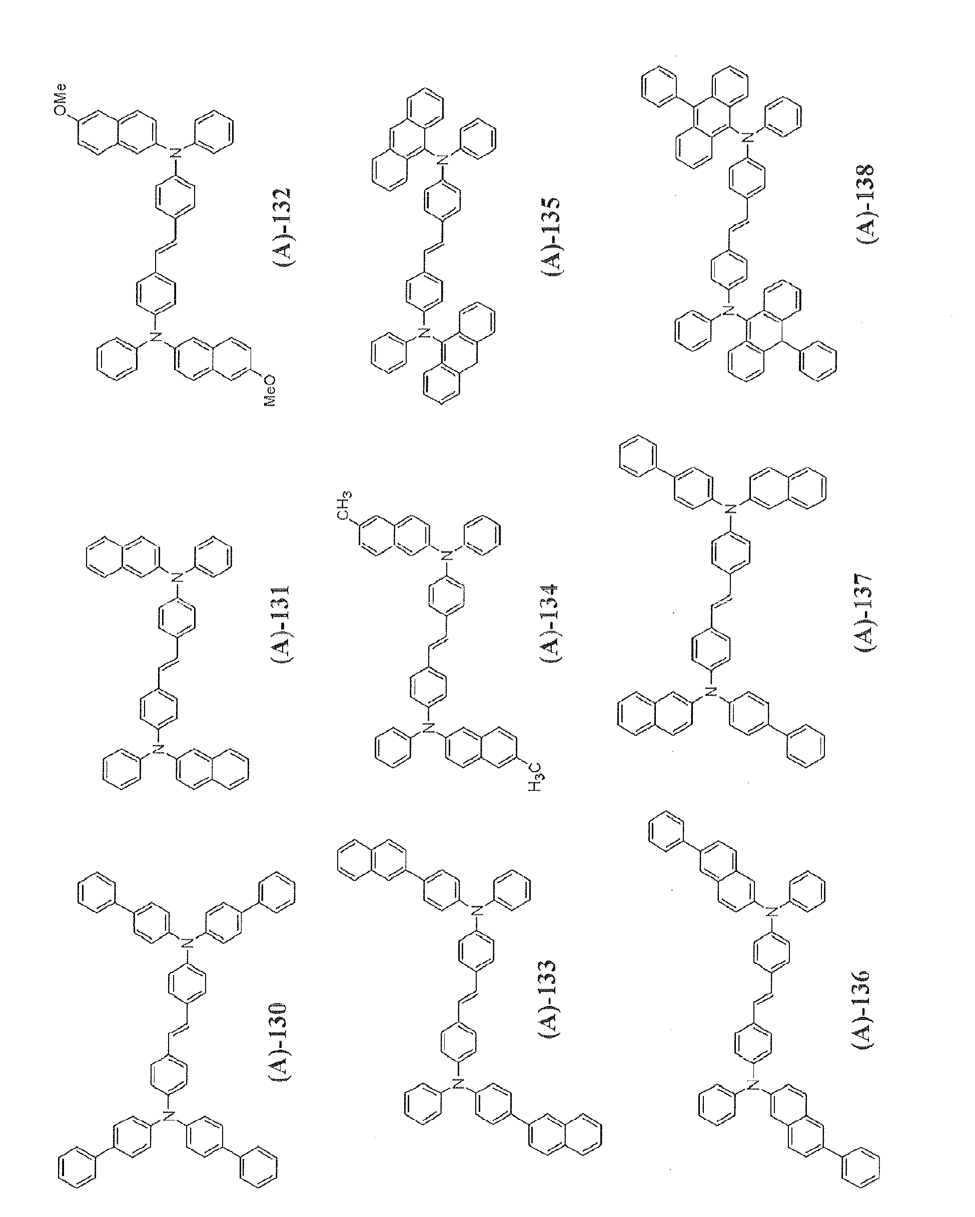

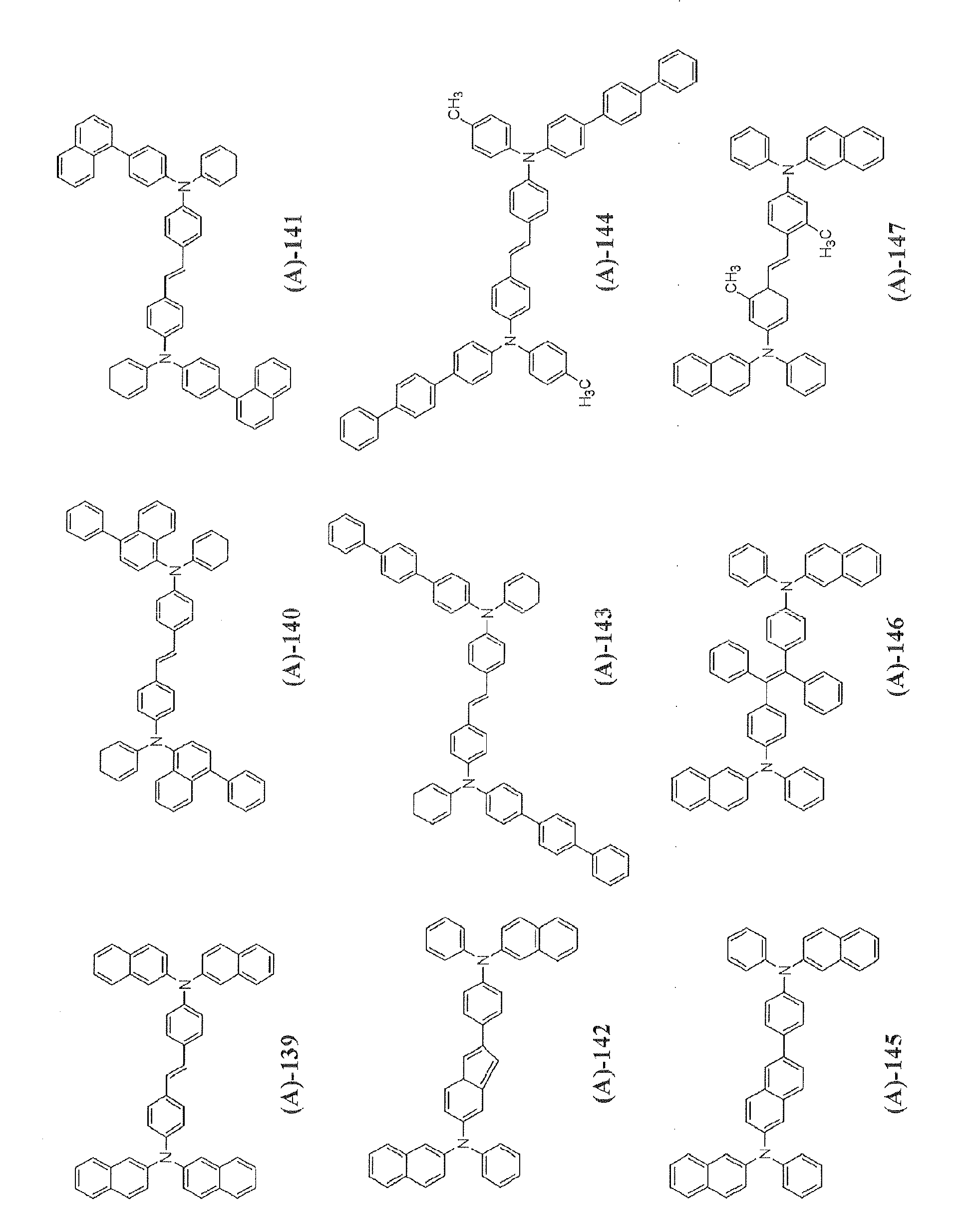

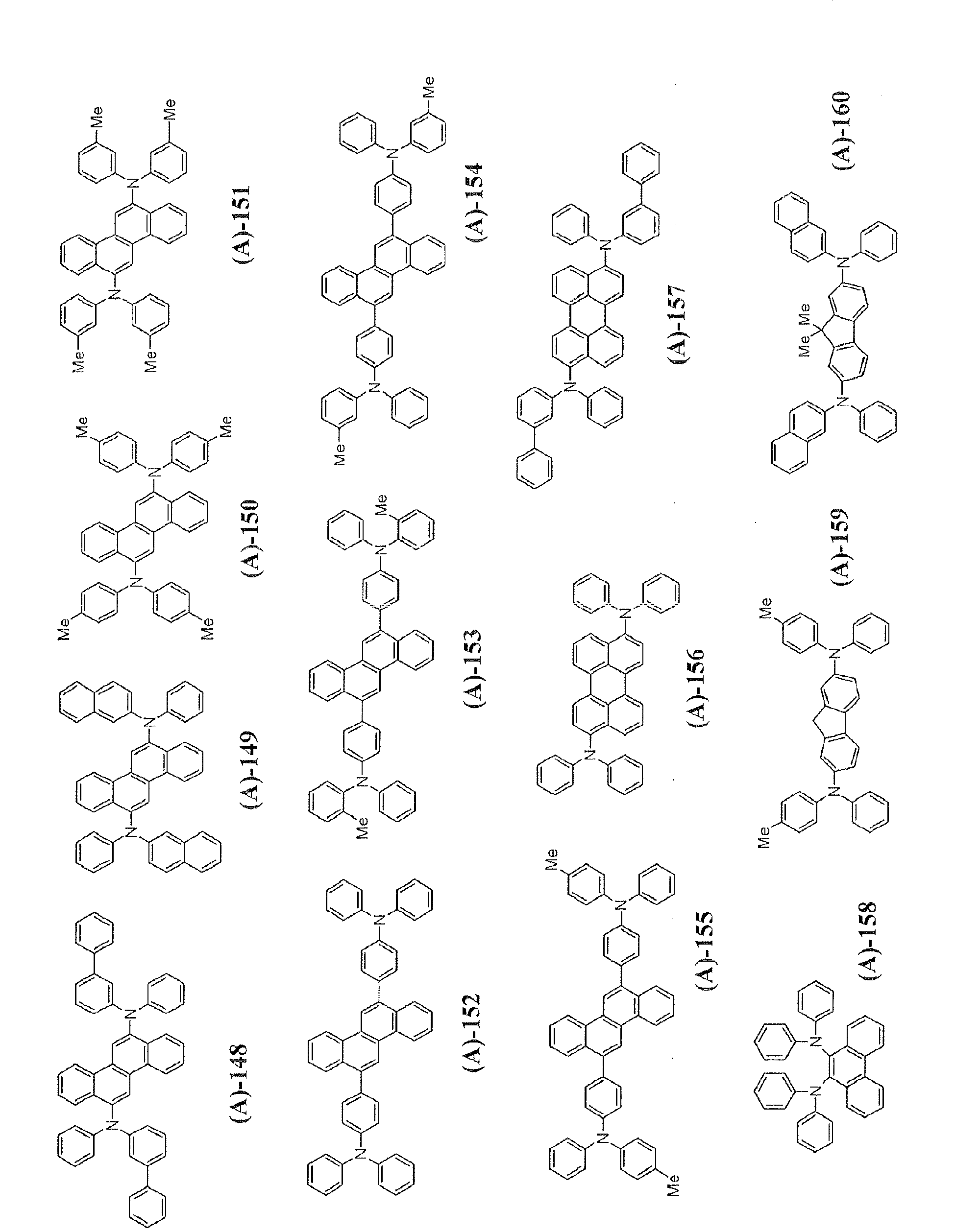

Further, although the compounds containing amine, which are contained in a light emitting layer of the organic EL devices (1) and (2) of the present invention are not limited, the styryl derivatives containing amine represented by the following general formula (V) are preferable as the compounds containing amine.

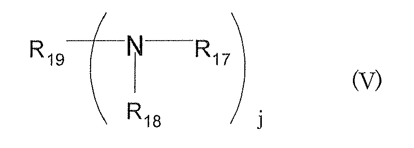

In the general formula (V), R₁₇ to R₁₉ each independently represents a monovalent aryl group having carbon atoms of 6 to 40, which may have substituent, or a monovalent hetero ring group having carbon atoms of 3 to 50, which may have substituent, at least one among them contains a styryl group, j represents an integer of 1 to 4, and the number of styryl groups is 1 to 4.
Examples of an aryl group and a hetero group of the aforementioned R₁₇ to R₁₉ include a phenyl group, a naphthyl group, an anthranyl group, a phenanthryl group, a pyrenyl group, a coronyl group, a biphenyl group, a terphenyl group, a fluorenyl group, a furanyl group, a thienyl group, a benzothienyl group, an indolyl group, a carbazolyl group, and a group comprising one of the above groups having at least a styryl group, and a phenyl group, a naphthyl group, a pyrenyl group, a biphenyl group, and a group comprising one of the above groups having at least a styryl group are preferable.
Further, substituent for R₁₇ to R₁₉ includes an alkyl group having carbon atoms of 1 to 6, a cycloalkyl group having carbon atoms of 3 to 6, an alkoxyl group having carbon atoms of 1 to 6, an aryloxy group having carbon atoms of 5 to 18, an aralkyloxy group having carbon atoms of 7 to 18, an arylamino group having carbon atoms of 5 to 16, a nitro group, a cyano group, an ester group having carbon atoms of 1 to 6, and a halogen atom.

Examples of a styryl derivative containing amine represented by the aforementioned general formula (V) are illustrated as follows, but not limited thereto.

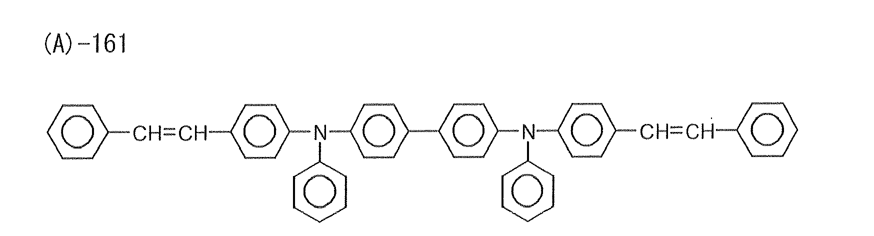

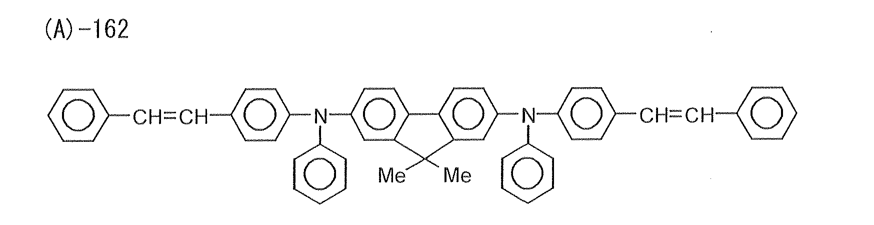

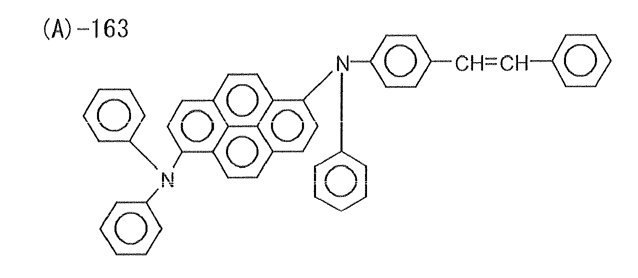

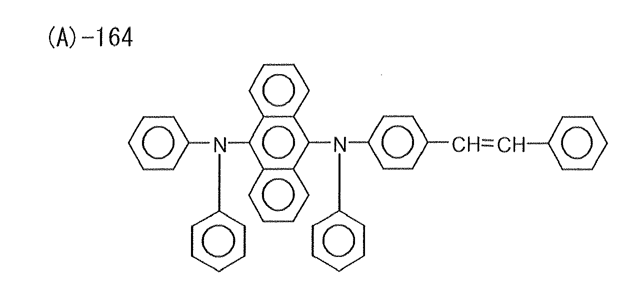

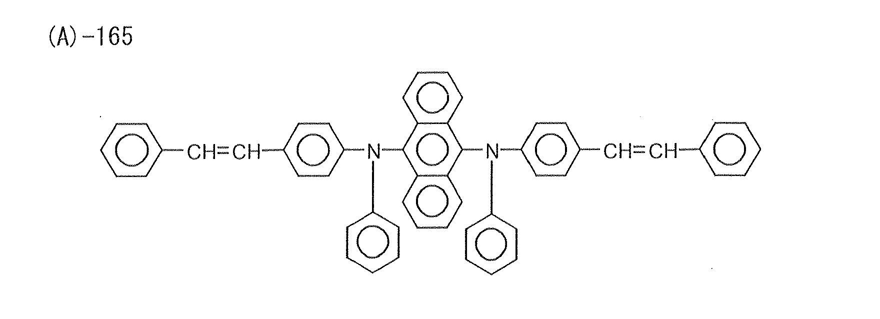

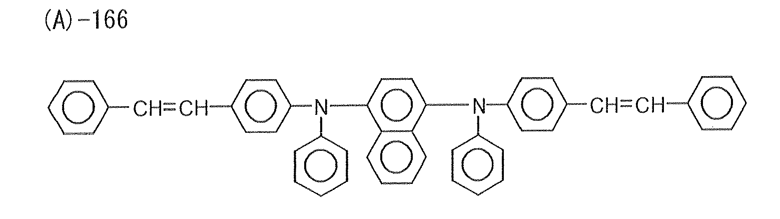

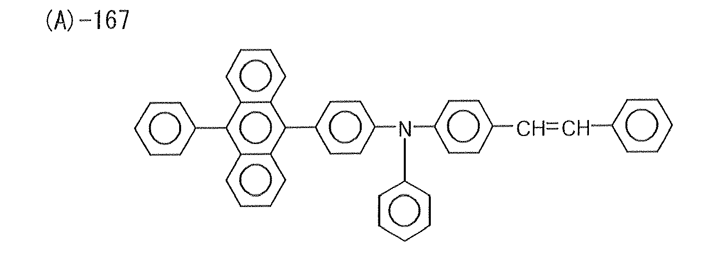

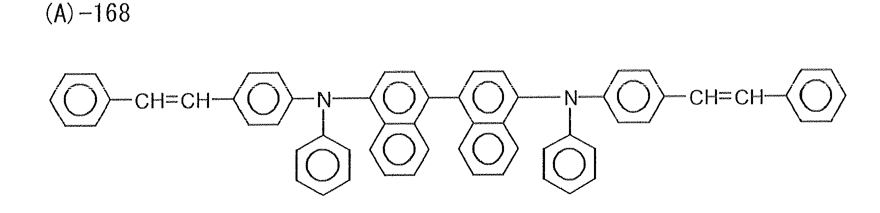

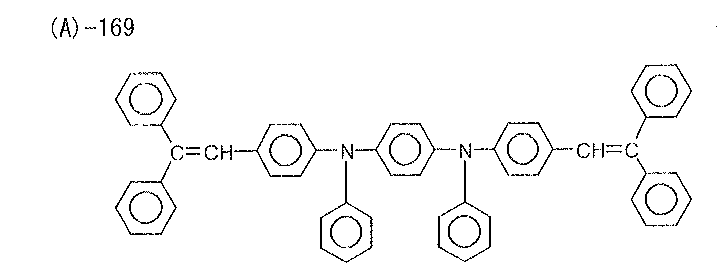

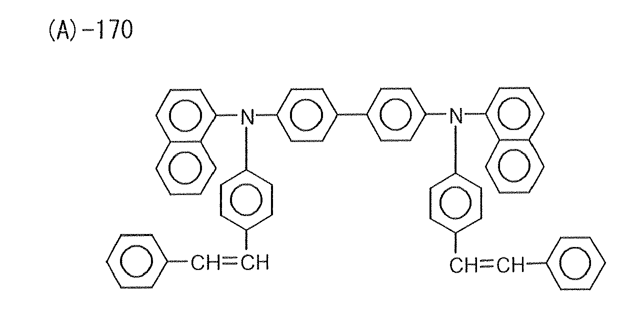

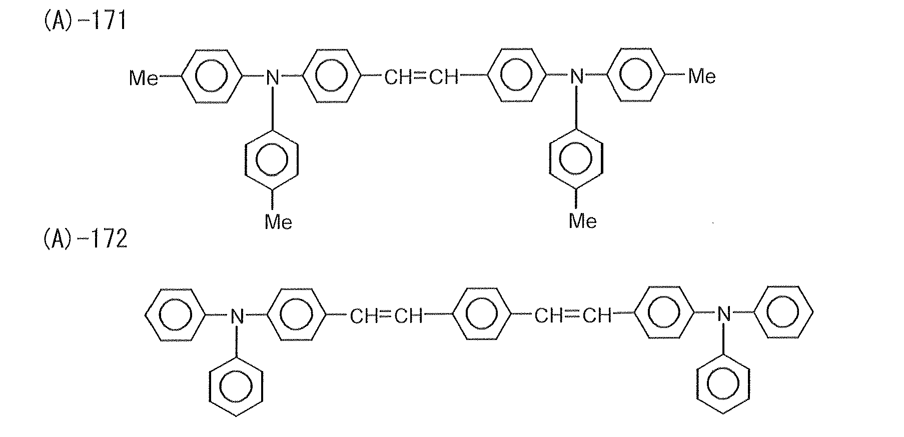

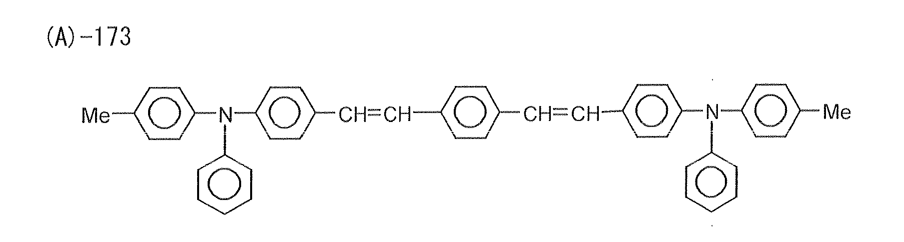

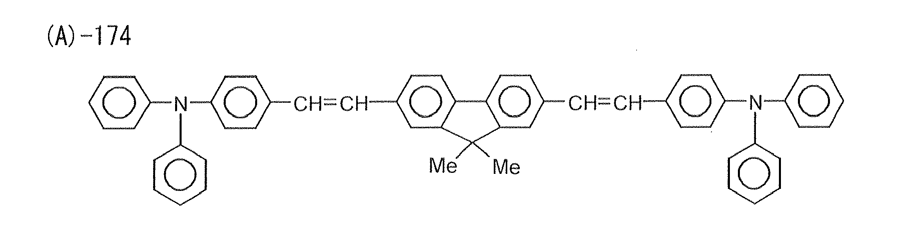

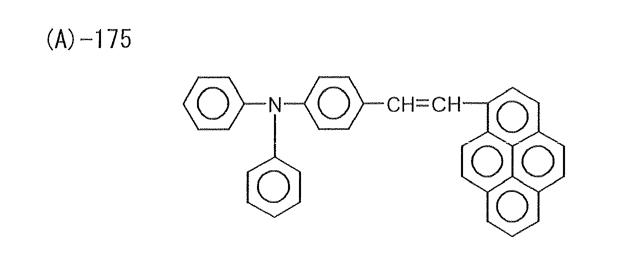

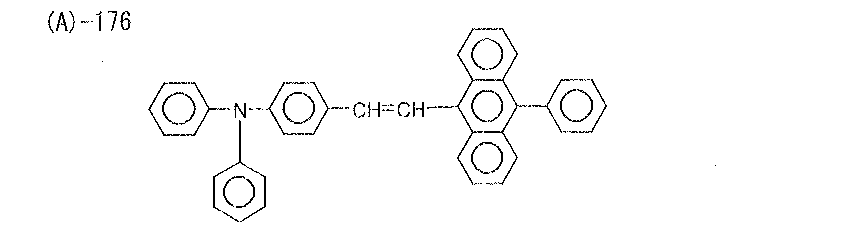

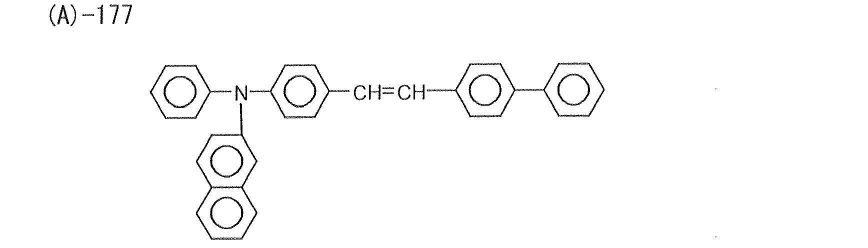

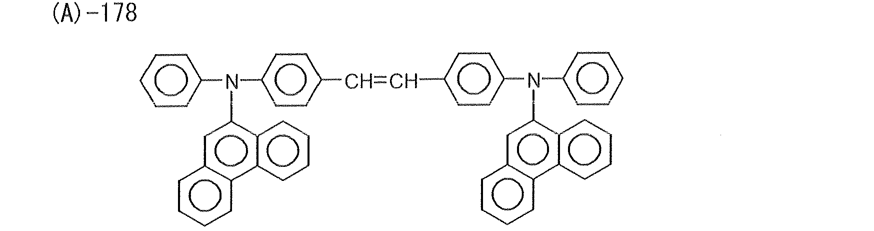

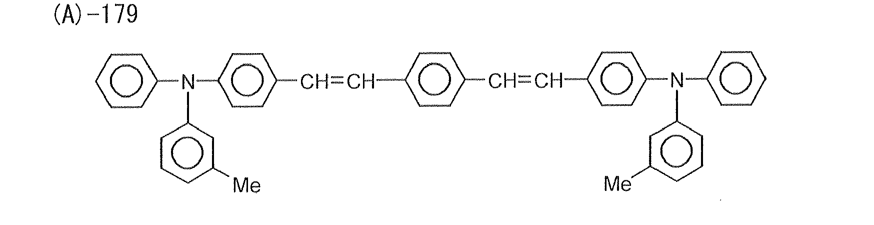

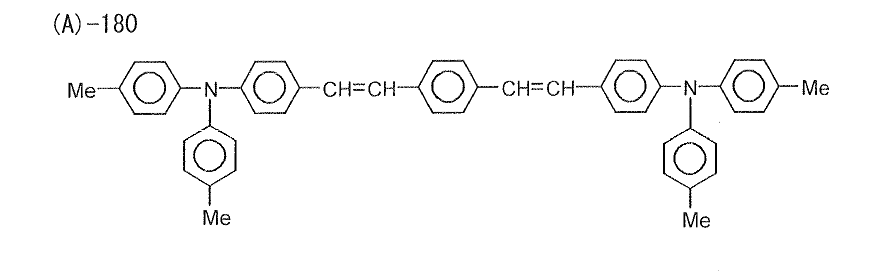

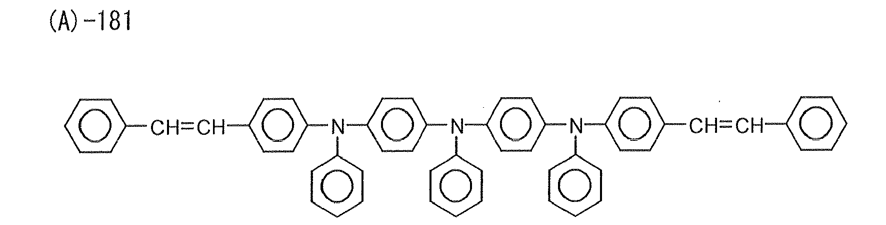

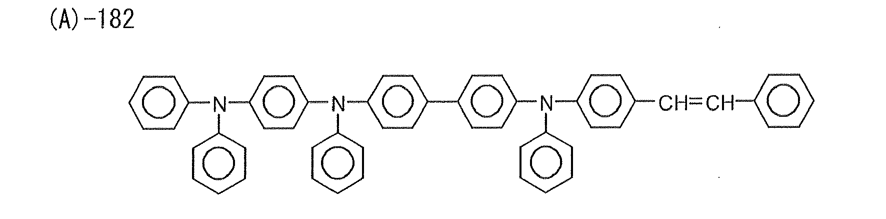

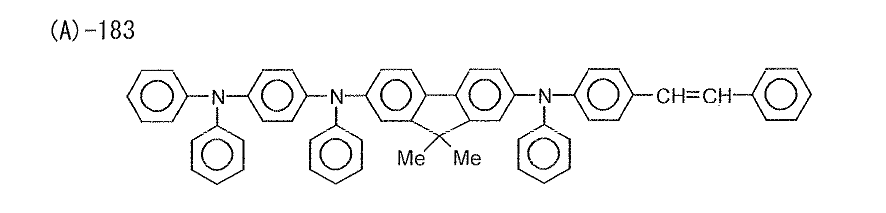

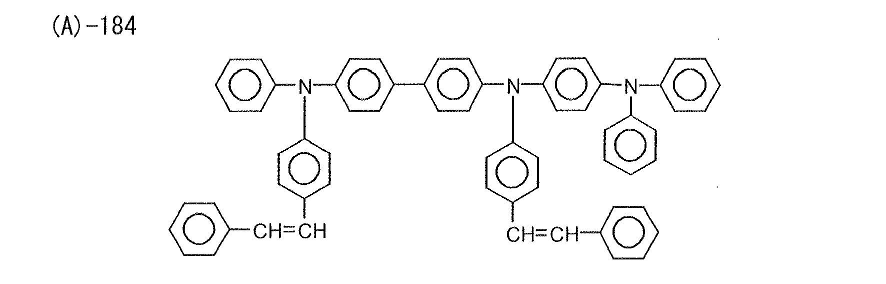

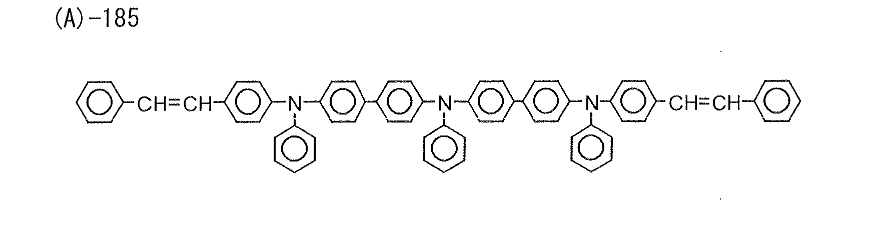

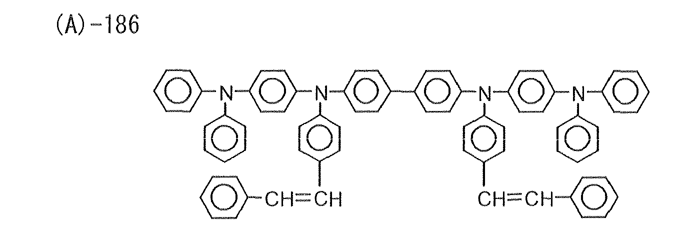

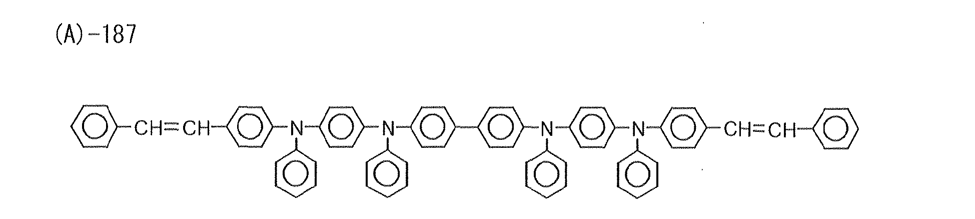

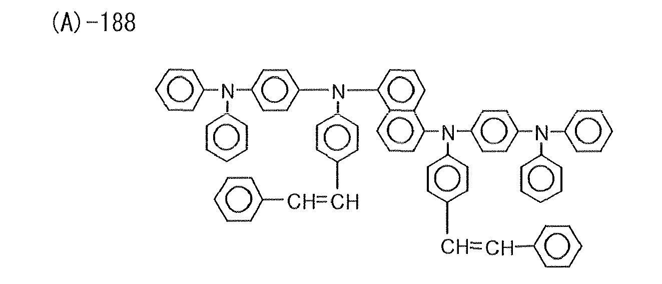

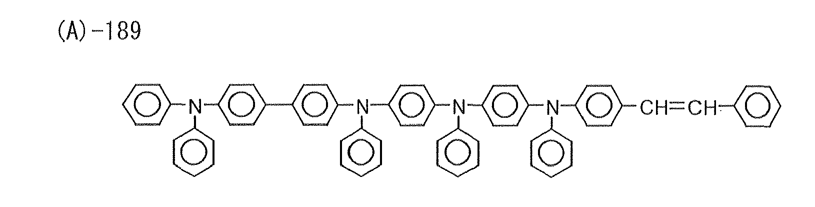

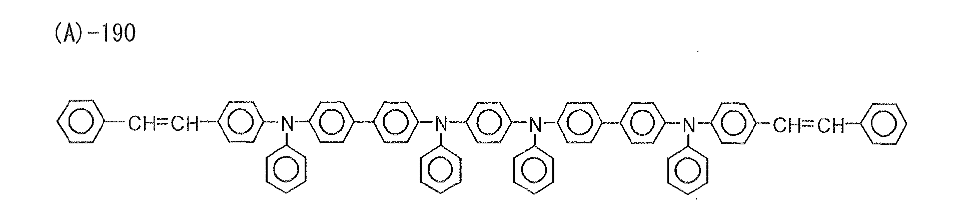

In the organic EL device (1) of the present invention, it is preferable that a host material comprises at least a compound selected from the silacyclopentadiene derivatives represented by the general formula (I) and the borane derivatives represented by the general formula (II), and a dopant comprises at least a compound selected from the compounds containing amine.
In the organic EL device (2) of the present invention, it is preferable that a host material comprises at least a compound selected from the silacyclopentadiene derivatives represented by the general formula (III), and a dopant comprises at least a compound selected from the compounds containing amine.
Further, in the organic EL device of the present invention, it is preferable to contain the compounds containing amine in the range of from 0.01 to 20 % by weight, preferably 1 to 20 % by weight in the light emitting layer.
Additionally, emitted light in the range of from blue to pure red by the organic EL devices of the present invention may be distinguished though the maximum emission wavelength of the emission spectra:
blue (maximum emission wavelength: 410 to 485 nm),
blue-green (maximum emission wavelength: 485 to 500 nm),
green (maximum emission wavelength: 500 to 530 nm),
yellow (maximum emission wavelength: 530 to 585 nm),
orange (maximum emission wavelength: 585 to 595 nm),
red (maximum emission wavelength: 595 to 620 nm), and
pure red (maximum emission wavelength: 620 to 700 nm).

The organic EL device of the present invention comprises at least an organic compound layer comprising a layer or a plural layer including a light emitting layer, interposed between a pair of electrodes, and also it is preferable to put various intermediate layers between the electrodes and the organic compound layer. The intermediate layers include, for example, a hole injecting layer, a hole transporting layer, an electron injecting layer, an electron transporting layer, and the like. A variety of organic or inorganic compounds has been known for them.
Typical examples of the construction of the organic EL device of the present invention include:
(1) an anode / a light emitting layer / a cathode
(2) an anode / a hole injecting layer / a light emitting layer / a cathode;
(3) an anode / a light emitting layer / an electron injecting layer / a cathode;
(4) an anode / a hole injecting layer / a light emitting layer / an electron injecting layer / a cathode;
(5) an anode / an organic semiconductor layer / a light emitting layer / a cathode;
(6) an anode / an organic semiconductor layer / an electron barrier layer / a light emitting layer / a cathode;
(7) an anode / an organic semiconductor layer / a light emitting layer / an adhesion improving layer / a cathode;
(8) an anode / a hole injecting layer / a hole transporting layer / a light emitting layer / an electron injecting layer / a cathode;
(9) an anode / an insulating layer / a light emitting layer / an insulating layer / a cathode;
(10) an anode / an inorganic semiconductor layer / an insulating layer / a light emitting layer / an insulating layer / a cathode;
(11) an anode / an organic semiconductor layer / an insulating layer / a light emitting layer / an insulating layer / a cathode;
(12) an anode / an insulating layer / a hole injecting layer / a hole transporting layer / a light emitting layer / an insulating layer / a cathode; and
(13) an anode / an insulating layer / a hole injecting layer / a hole transporting layer / a light emitting layer / an electron injecting layer / a cathode.
   Among those, the construction (8) is generally employed in particular; however, the construction of the organic EL device is not limited to those shown above as the examples.

In general, the organic EL device is produced on a substrate which transmits light. It is preferable that the substrate which transmits light has a transmittance of light of 50% or greater in the visible region of 400 to 700 nm. It is also preferable that a flat and smooth substrate is employed. As the substrate which transmits light, for example, glass sheet and synthetic resin sheet are advantageously employed. Specific examples of the glass sheet include soda ash glass, glass containing barium and strontium, lead glass, aluminosilicate glass, borosilicate glass, barium borosilicate glass, quartz and the like. In addition, specific examples of the synthetic resin sheet include sheet made of polycarbonate resins, acrylic resins, polyethylene terephthalate resins, polyether sulfide resins, polysulfone resins and the like.

Next, the anode in the organic EL device of the present invention comprises preferably electrode materials such as metal, alloy, electric conductive compounds or mixture thereof, which have a work function of 4 eV or greater.
Examples of the electrode material include metal such as Au and electric conductive materials such as CuI, ITO (indium tin oxide), SnO₂, ZnO, and In-Zn-O. The anode can be prepared by forming a thin film of the electrode material described above in accordance with a process such as a vapor deposition process or a sputtering process. When the light emitted from the light emitting layer is observed through the anode, it is preferable that the anode has a transmittance of the emitted light greater than 10 %. It is also preferable that the sheet resistivity of the anode is several hundred Ω/□ or smaller.
In addition, the thickness of the anode is, in general, selected in the range of from 10 nm to 1µm and preferably in the range of from 10 to 200 nm depending on a kind of the materials.

Next, the cathode in the organic EL device of the present invention comprises electrode materials such as metal, alloy, electric conductive compounds or mixture thereof, which have a work function of 4 eV or smaller.
Examples of the electrode material include sodium, sodium-potassium alloy, magnesium, lithium, magnesium-silver alloy, aluminum/aluminum oxide, Al/Li₂O, Al/LiO₂, Al/LiF, aluminum/lithium alloy, indium, rare earth metal, and the like. The cathode can be prepared by forming a thin film of the electrode material described above in accordance with a process such as the vapor deposition process and the sputtering process. When the light emitted from the light emitting layer is observed through the cathode, it is preferable that the cathode has a transmittance of the emitted light greater than 10 %. It is also preferable that the sheet resistivity of the cathode is several hundred Ω/□ or smaller. The thickness of the cathode is, in general, selected in the range of from 10 nm to 1 µm and preferably in the range of from 50 to 200 nm.

In the organic EL device of the present invention, it is preferable to allocate at least a layer ("a layer" will be occasionally referred to as "a surface layer", hereinafter) selected from the group consisting of a chalcogenide layer, a metal halide layer and a metal oxide layer on at least a surface of the pair of the electrodes prepared as above. Specifically, it is preferable to allocate a chalcogenide layer of metal (including oxide) such as silicon and aluminum on the anode surface on the side of the layer, and a metal halide layer or a metal oxide layer on the cathode surface on the side of the organic compound layer. The allocation results in stabilization of driving.
The above chalcogenide includes, for example, preferably SiOx(1≦X≦2), AlOₓ(1 ≦ X ≦ 1.5), SiON, SiAlON, and the like. The metal halide includes, for example, preferably LiF, MgF₂, CaF₂, rare earth metal fluoride, and the like. The metal oxide includes, for example, preferably, Cs₂O, Li₂O, MgO, SrO, BaO, CaO and the like.

In addition, in the organic EL device of the present invention, since it is preferable to allocate a mixture zone of an electron transfer compound and a reductive dopant, or a mixture zone of a hole transfer compound and an oxidative dopant on at least a surface of the pair of the electrodes prepared as above.
In this way, it becomes easy to inject and transport electrons from the mixture zone into the light emitting medium, since the electron transfer compound is reduced to anion.
Further, the hole transfer compound is oxidized to cation and the mixture zone is apt to inject and transport holes into the light emitting medium. Examples of preferable oxidative dopant include a variety of Lewis acids and acceptor compounds. Examples of preferable reductive dopant include alkali metals, alkali metal compounds, alkaline earth metals, rare earth metals, and a mixture thereof.

In the organic EL device of the present invention, the light emitting layer has the following functions:
(i) The injecting function: the function of injecting holes from the anode or the hole injecting layer and injecting electrons from the cathode or the electron injecting layer when an electric field is applied;
(ii) The transporting function: the function of transporting injected charges (electrons and holes) by the force of the electric field; and
(iii) The light emitting function: the function of providing the field for recombination of electrons and holes and leading the recombination to the emission of light.
As the process for forming the light emitting layer and the organic compound layer comprising the light emitting layer, a well known process such as the vapor deposition process, the spin coating process and the LB process may be employed.
It is preferable that a light emitting layer and the organic compound layer are a molecular sedimentation film particularly.
Here, the molecular sedimentation film is defined as a thin film formed by sedimentation of a gas phase material compound or a film formed by condensation of a liquid phase material compound. The molecular sedimentation film may be differentiated from a thin film (a molecular build-up film) formed by the LB process, based on the differences between agglomeration structures and higher-order structures, and also the differences resulting from functionalities thereof.

In addition, as shown in Japanese Patent Laid-open No. Showa 57(1982)-51781, to form an organic compound layer, a thin film may be formed in accordance with the spin coating and the like of the solution to be prepared by dissolving a binder such as resin and a material compound in solvent. In the present invention, any well known organic compounds other than the components (I) and (V) may be optionally contained in the organic compound layer, and also an organic compound layer containing other well known organic compounds may be laminated with the organic compound layer containing the compounds of the present invention in an extent of not obstructing to achieve the objective of the present invention. A thickness of the organic light emitting layer may be preferably 5 to 200 nm, and more preferably 10 to 40 nm since it is possible to make impressed voltage of a device significantly low.

In the organic EL device of the present invention, employing a combination of a light emitting layer comprising at least a compound selected from the silacyclopentadiene derivatives represented by the general formula (I) and the borane derivatives represented by the general formula (II), or at least a compound selected from the silacyclopentadiene derivatives represented by the general formula (III) with at least a compound selected from compounds containing amine, enables the light emitting layer to be amorphous state, which resulting in controlling crystallization, improving stability and having excellent heat resistance thereof.
A material having glass temperature of 100 °C or higher is preferable for the host material. It is possible to have the organic light emitting layer having a glass transition temperature of 110 °C or higher resulting from mixing compounds having such glass transition temperatures. Therefore, it is possible to provide with the layer having storage heat resistance of 500 hours or longer at 85 °C.
In addition, it is possible to control the chromaticity of an emitted light or the maximum wavelength of emission spectra by adjusting the blending ratio between a host material and a dopant. Namely, it is possible to move the peak of emission spectra further a long wavelength by increasing the part of a dopant therein. This is because the emission spectrum involving with the dopant is a long wavelength.
Therefore, it may be possible to reproduce color in the range of from blue to green, or red if a variety of dopant is suitably selected.

Next, the hole injecting / transporting layers are layers which assist injection of holes into the light emitting layer and transport the holes to the light emitting zone. The layers exhibit a great mobility of holes and, in general, have an ionization energy as small as 5.5 eV or smaller. For the hole injecting layer and the hole transporting layer, a material which transports holes to the light emitting layer at a small strength of the electric field is preferable. A material which exhibits, for example, a mobility of holes of at least 10⁻⁶ cm²/V·sec under application of an electric field of from 10⁴ to 10⁶ V/cm is preferable. As for such material, any arbitrary material selected from conventional material commonly used as a charge transporting material for the holes in photoconducting materials and well known material employed for the hole injecting layer in the EL device is usable.
To form the hole injecting / transporting layer, a thin film may be formed from the material for the hole injecting layer or the hole transporting layer, respectively, in accordance with a well known process such as the vacuum vapor deposition process, the spin coating process, the casting process and the LB process. Although the thickness of the hole injecting / transporting layer is not particularly limited, the thickness is usually from 5 nm to 5 µm.

The electron injection / transporting layer in the organic EL device of the present invention is a layer which assists injection of electrons into the light emitting layer, transports electrons to light emitting zone, and exhibits a great mobility of electrons. As the material for the electron injecting layer, 8-hydroxyquinoline or metal complexes of derivatives thereof are preferable.
Examples of the 8-hydroxyquinoline and metal complexes of derivatives thereof include metal chelates of oxynoid compounds including chelates of oxine (in general, 8-quinolinol or 8-hydroxyquinoline). For example, tris(8-quinolinol)almninum (Alq) can be employed as the electron injecting material.
In general, an organic EL device tends to form defects in pixels due to leak and short circuit since an electric field is applied to ultra-thin films. To prevent the formation of the defects, a layer of an insulating thin film may be inserted between the pair of electrodes.

Examples of the material employed for the insulating layer include aluminum oxide, lithium fluoride, lithium oxide, cesium fluoride, cesium oxide, magnesium oxide, magnesium fluoride, calcium oxide, calcium fluoride, aluminum nitride, titanium oxide, silicon oxide, germanium oxide, silicon nitride, boron nitride, molybdenum oxide, ruthenium oxide, vanadium oxide and the like. Mixtures and laminates of the above compounds can also be employed.
To produce an organic EL device of the present invention, for example, an anode, a light emitting medium layer and, where necessary, a hole injecting layer and an electron injecting layer are formed in accordance with the aforementioned process using the aforementioned materials, and a cathode is formed in the last step.
An organic EL device may be produced by forming the aforementioned layers in the order reverse to that described above, i.e., a cathode being formed in the first step and an anode in the last step.

An embodiment of the process for producing an organic EL device having a construction in which an anode, a hole injecting layer, a light emitting medium layer, an electron injecting layer and a cathode are disposed sequentially on a light-transmitting substrate will be described in the following. On a suitable light-transznitting substrate, a thin film made of a material for the anode is formed in accordance with the vapor deposition process or the sputtering process so that the thickness of the formed thin film is 1 µm or smaller and preferably in the range of from 10 to 200 nm. The formed thin film is employed as the anode. Next, the hole injecting layer was formed on the anode formed above. The hole injecting layer can be formed in accordance with the vacuum vapor deposition process, the spin coating process, the casting process or the LB process, as described above. The vacuum vapor deposition process is preferable since a uniform film can be easily obtained and the possibility of formation of pin holes is small. When the hole injecting layer is formed in accordance with the vacuum vapor deposition process, in general, it is preferable that the conditions are suitably selected in the following ranges: temperature of the deposition source: 50 to 450 °C; vacuum level: 10⁻⁷ to 10⁻³ Torr; deposition rate: 0.01 to 50 nm/second; temperature of the substrate: -50 to 300°C; and film thickness: 5 nm to 5 µm; although the conditions of the vacuum vapor deposition are different depending on the employed compound (the material for the hole injecting layer) and the crystal structure and the recombination structure of the hole injecting layer to be formed.

Subsequently, the light emitting medium layer is formed on the hole injecting layer formed above. Also the formation of the light emitting medium layer can be made by forming the light emitting medium according to the present invention into a thin film in accordance with the vacuum vapor deposition process, the sputtering process, the spin coating process or the casting process. The vacuum vapor deposition process is preferable since a uniform film can be easily obtained and the possibility of formation of pinholes is small.
Then the light emitting medium layer is formed in accordance with the vacuum vapor deposition process, in general, the conditions of the vacuum vapor deposition process can be selected in the same ranges as those described for the vacuum vapor deposition of the hole injecting layer although the conditions are different depending on a compound. It is preferable that the thickness is in the range of from 10 to 40 nm.
Next, the electron injecting layer is formed on the light emitting medium layer formed above. Similarly to the hole injecting layer and the light emitting medium layer, it is preferable that the electron injecting layer is formed in accordance with the vacuum vapor deposition process since a uniform film must be obtained. The conditions of the vacuum vapor deposition can be selected in the same ranges as those for the hole injecting layer and the light emitting medium layer. In the last step, the cathode is formed on the electron injecting layer, and an organic EL device can be fabricated. The cathode is made of a metal and can be formed in accordance with the vacuum vapor deposition process or the sputtering process. It is preferable that the vacuum vapor deposition process is employed in order to protect the lower organic layers from damages during the formation of the film.
In the above production of the organic EL device, it is preferable that the above layers from the anode to the cathode are formed successively while the production system is kept in a vacuum after being evacuated.

In the case of that a direct voltage is applied on the organic EL device produced in the above manner, when a direct voltage of 3 to 40 V is applied in the condition that the anode is connected to a positive electrode (+) and the cathode is connected to a negative electrode (-), then a light emitting is observed. When the connection is reversed, no electric current is produced and no light is emitted at all.
When an alternating voltage is applied on the organic EL device, the uniform light emission is observed only in the condition that the polarity of the anode is positive and the polarity of the cathode is negative. When an alternating voltage is applied on the organic EL device, any type of wave shape can be employed.

### Example

This invention will be described in further detail with reference to the examples, which do not limit the scope of this invention.

### Example 1

On a glass substrate of 25 mm×75 mm×1.1 mm thickness, a transparent electrode of an indium tin oxide film having a film thickness of 130 nm was allocated. The above glass substrate was cleaned by application of ultraviolet rays and by exposure to ozone, and then it was set to a vacuum vapor deposition apparatus. As a hole injecting layer, 4,4'-bis(N,N-di-(3-tolyl)-4-aminophenyl)-4"-phenyl- triphenylamine was deposited on the substrate, thereby forming a film having a film thickness of 60 nm, and then as a hole transporting layer, N,N'-bis[4'-{N-(naphtyl-1-yl)-N-phenyl}aminobiphenyl-4-yl]-N-phenylamine was deposited thereby forming a film having a thickness of 20 nm. Subsequently, as a light emitting layer, the silacyclopentadiene derivative of (B)-1 and the styryl based derivative of (A)-161 at the ratio by weight of 40 : 3 were deposited at the same time thereby forming a film having a film thickness of 40 nm. Further, as an electron injecting layer, tris(8-hydroxyquinolinato)aluminum was deposited thereby forming a film having a film thickness of 20 nm. Thereafter, lithium fluoride was deposited thereby forming a film having a film thickness of 0.3 nm, followed by deposition of aluminum to form a film having a film thickness of 150 mn. The aluminum / lithium fluoride worked as a cathode. Thus the organic EL device was fabricated. The device was tested under an electricity application, a blue light emission with an emission luminance of 150 cd/m² was observed at a voltage of 6.5 V and a current density of 10 mA/cm².

### Example 2

On a glass substrate of 25 mm×75 mm×1.1 mm thickness, a transparent electrode of an indium tin oxide film having a film thickness of 80 nm was allocated. The above glass substrate was cleaned by application of ultraviolet rays and by exposure to ozone, and then it was set to a vacuum vapor deposition apparatus. As a hole injecting layer, 4,4'-bis(N,N-di-(3-tolyl)-4-aminophenyl)-4"-phenyl-triphenylamine was deposited on the substrate, thereby forming a film having a film thickness of 60 nm, and then as a hole transporting layer, N,N'-bis[4-(diphenylamino)phenyl]-N-N'-diphenylbiphenyl-4-4'-diamine was deposited thereby forming a film having a thickness of 20 nm. Subsequently, as a light emitting layer, the silacyclopentadiene derivative of (B)-2 and the condensed aromatic ring derivative containing amine of (A)-93 at the ratio by weight of 40 : 3 were deposited at the same time thereby forming a film having a film thickness of 40 nm. Further, as an electron injecting layer, tris(8-hydroxyquinolinato)aluminum was deposited thereby forming a film having a film thickness of 20 nm.
Thereafter, lithium fluoride was deposited thereby forming a film having a film thickness of 0.3 nm, followed by deposition of aluminum to form a film having a film thickness of 150 nm. The aluminum / lithium fluoride worked as a cathode. Thus the organic EL device was fabricated.
The device was tested under an electricity application, a green light emission with an emission luminance of 1500 cd/m² was observed at a voltage of 6.5 V and a current density of 10 mA/cm².

### Example 3

On a glass substrate of 25 mm×75 mm×1.1 mm thickness, a transparent electrode of an indium tin oxide film having a film thickness of 180 nm was allocated. The above glass substrate was cleaned by application of ultraviolet rays and by exposure to ozone, and then it was set to a vacuum vapor deposition apparatus. As a hole injecting layer, 4,4'-bis(N,N-di-(3-tolyl)-4-aminophenyl)-4"-phenyltriphenylamine was deposited on the substrate, thereby forming a film having a film thickness of 60 nm, and then as a hole transporting layer, N,N',N',N'-tetrakis(4-biphenyl)-4,4'-benzidine was deposited thereby forming a film having a thickness of 20 nm. Subsequently, as a light emitting layer, the silacyclopentadiene derivative of (B)-3 and the condensed aromatic ring derivative containing amine of (A)- 124 at the ratio by weight of 40 : 10 were deposited at the same time thereby forming a film having a film thickness of 40 nm. Further, as an electron injecting layer, tris(8-hydroxyquinolinato)aluminum was deposited thereby forming a film having a film thickness of 20 nm. Thereafter, lithium fluoride was deposited thereby forming a film having a film thickness of 0.3 nm, followed by deposition of aluminum to form a film having a film thickness of 150 nm.
The device was tested under an electricity application, a red light emission with an emission luminance of 200 cd/m² was observed at a voltage of 8.5 V and a current density of 10 mA/cm².

### Example 4

An organic device was fabricated similarly as Example 3 except that the silacyclopentadiene derivative of (B)-15 and the condensed aromatic ring derivative containing amine of (A)-129, in place of the silacyclopentadiene derivative of (B)-3 and the condensed aromatic ring derivative containing amine of (A)-124, at the ratio by weight of 40 : 10 were deposited at the same time thereby forming a light emitting layer having a film thickness of 40 nm.
The device was tested under an electricity application, a pure red light emission with an emission luminance of 170 cd/m² was observed at a voltage of 8.5 V and a current density of 10 mA/cm².

### Comparative Example 1

An organic device was fabricated similarly as Example 1 except that the compound (B)-1 only in place of the compounds (B)-1 and (A)-161 was used to form a light emitting layer having a film thickness of 40 nm. The device was tested under an electricity application, a blue light emission with an emission luminance of 1 cd/m² was observed at a voltage of 6.5 V and a current density of 10 mA/cm².
The device did not emit any light after several minutes.

### Comparative Example 2

An organic device was fabricated similarly as Example 2 except that 3-(2'-benzothiazoyl)-7-diethylaminocoumarin in place of the compound (A)-93 was used to form a light emitting layer.
The device was tested under an electricity application, a green light emission with an emission luminance of 900 cd/m² was observed at a voltage of 6.5 V and a current density of 10 mA/cm².

### Comparative Example 3

An organic device was fabricated similarly as Example 3 except that 4-dicyanomethylene-6-julolidinostyryl-2-tert-butyl-4H-pyran in place of the compound (A)-124 was used to form a light emitting layer.
The device was tested under an electricity application, a red light emission with an emission luminance of 80 cd/m² was observed at a voltage of 8.5 V and a current density of 10 mA/cm².

### INDUSTRIAL APPLICABILITY

As explained above in details, the organic EL device of the present invention has excellent heat resistance and a long lifetime, exhibits high current efficiency, and emits a light in the range of from blue to red. Therefore, it is useful for a practical organic EL device, and suitable for in particular a display for full color.

## Claims

1. An organic electroluminescent device comprising a pair of electrodes and at least an organic compound layer comprising a layer or a plural layer including a light emitting layer, interposed between the pair of electrodes, wherein the light emitting layer contains at least a compound selected from the silacyclopentadiene derivatives represented by the following general formula (I) and a compound selected from the compounds containing amine represented by the following general formula (II): 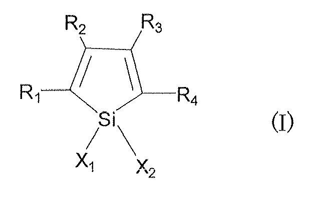 wherein, X₁ and X₂ each independently represents an alkyl group having carbon atoms of 1 to 6, which may have substituent, an alkenyl group having carbon atoms of 1 to 6, which may have substituent, an alkynyl group having carbon atoms of 1 to 6, which may have substituent, an alkoxy group having carbon atoms of 1 to 6, which may have substituent, an alkenyloxy group having carbon atoms of 1 to 6, which may have substituent, an alkynyloxy group having carbon atoms of 1 to 6, which may have substituent, a hydroxy group, an aryl group having carbon atoms of 5 to 50, which may have substituent, or a hetero ring group having carbon atoms of 3 to 50, which may have substituent, and also X₁ and X₂ may bond to form a saturated ring or an unsaturated ring;
R₁ to R₄ each independently represents a hydrogen atom, a halogen atom, an alkyl group having carbon atoms of 1 to 6, which may have substituent, an alkenyl group having carbon atoms of 1 to 6, which may have substituent, an alkynyl group having carbon atoms of 1 to 6, which may have substituent, an alkoxy group having carbon atoms of 1 to 6, which may have substituent, an alkenyloxy group having carbon atoms of 1 to 6, which may have substituent, an alkynyloxy group having carbon atoms of 1 to 6, which may have substituent, an aryl group having carbon atoms of 5 to 50, which may have substituent, a hetero ring group having carbon atoms of 3 to 50, which may have substituent, an aryloxy group having carbon atoms of 5 to 50, which may have substituent, an amino group, an alkylcarbonyl group having carbon atoms of 1 to 7, which may have substituent, an arylcarbonyl group having carbon atoms of 5 to 50, which may have substituent, an alkoxycarbonyl group having carbon atoms of 1 to 7, which may have substituent, an aryloxycarbonyl group having carbon atoms of 5 to 50, which may have substituent, an alkyloxycarbonyloxy group having carbon atoms of 1 to 7, which may have substituent, an aryloxycarbonyloxy group having carbon atoms of 5 to 50, which may have substituent, an alkoxycarbonyloxy group having carbon atoms of 1 to 7, which may have substituent, an aryloxycarbonyloxy group having carbon atoms of 5 to 50, which may have substituent, a sulfinyl group, which may have substituent, a sulfonyl group, a sulfanyl group, a silyl group, which may have substituent, a carbamoyl group, which may have substituent, a hydroxy group, a nitro group, a formyl group, a nitroso group, a formyloxy group, an isocyano group, a cyanate group, an isocyanate group, a thiocyanate group, an isothiocyanate group or a cyano group, and neighboring groups thereof may bond each other to form a saturated or unsaturated ring; 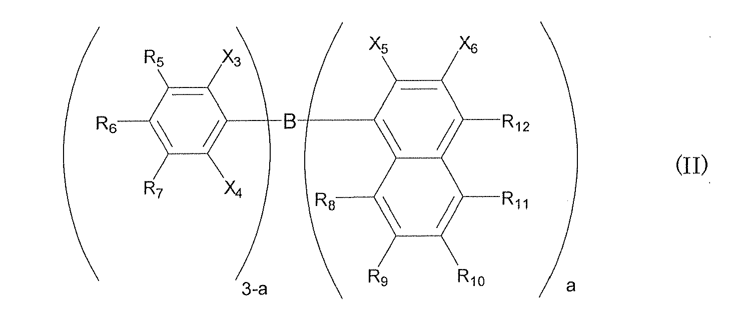 wherein, R₅ to R₁₂ and X₆ each independently represents a hydrogen atom, an alkyl group having carbon atoms of 1 to 6, which may have substituent, an alkenyl group having carbon atoms of 1 to 6, which may have substituent, an alkynyl group having carbon atoms of 1 to 6, which may have substituent, an aryl group having carbon atoms of 5 to 50, which may have substituent, a hetero ring group having carbon atoms of 3 to 50, which may have substituent, a substituted amino group, a substituted boryl group, an alkoxy group having carbon atoms of 1 to 6, which may have substituent, or an aryloxy group having carbon atoms of 5 to 50, which may have substituent; X₃ to X₅ each independently represents an alkyl group having carbon atoms of 1 to 6, which may have substituent, an alkenyl group having carbon atoms of 1 to 6, which may have substituent, an alkynyl group having carbon atoms of 1 to 6, which may have substituent, an aryl group having carbon atoms of 5 to 50, which may have substituent, a hetero ring group having carbon atoms of 3 to 50, which may have substituent, a substituted amino group, a silyl group, which may have substituent, a substituted boryl group, an alkoxy group having carbon atoms of 1 to 6, which may have substituent, or an aryloxy group having carbon atoms of 5 to 50, which may have substituent; X₅ and X₆ may bond each other to form a saturated or unsaturated ring, a represents an integer of 1 to 3.

2. An organic EL device comprising a pair of electrodes and at least an organic compound layer comprising a layer or a plural layer including a light emitting layer, interposed between the pair of electrodes, wherein the light emitting layer contains at least a compound selected from the silacyclopentadiene derivatives represented by the following general formula (III), and at least a compound selected from the compounds containing amine: 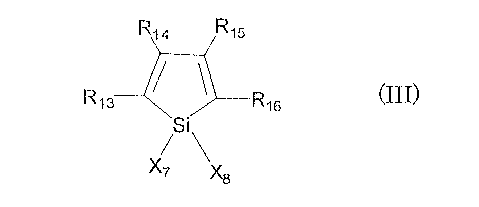 wherein, X₇ and X₈ each independently represents an alkyl group having carbon atoms of 1 to 6, which may have substituent, an alkenyl group having carbon atoms of 1 to 6, which may have substituent, an alkynyl group having carbon atoms of 1 to 6, which may have substituent, an alkoxy group having carbon atoms of 1 to 6, which may have substituent, an alkenyloxy group having carbon atoms of 1 to 6, which may have substituent, an alkynyloxy group having carbon atoms of 1 to 6, which may have substituent, a hydroxy group, an aryl group having carbon atoms of 5 to 50, which may have substituent, or a hetero ring group having carbon atoms of 3 to 50, which may have substituent, and also X₇ and X₈ may bond to form a saturated ring or an unsaturated ring;
R₁₃ to R₁₆ each independently represents a hydrogen atom, a halogen atom, an alkyl group having carbon atoms of 1 to 6, which may have substituent, an alkenyl group having carbon atoms of 1 to 6, which may have substituent, an alkynyl group having carbon atoms of 1 to 6, which may have substituent, an alkoxy group having carbon atoms of 1 to 6, which may have substituent, an alkenyloxy group having carbon atoms of 1 to 6, which may have substituent, an alkynyloxy group having carbon atoms of 1 to 6, which may have substituent, an aryl group having carbon atoms of 5 to 50, which may have substituent, an aryloxy group having carbon atoms of 5 to 50, which may have substituent, an amino group, an alkylcarbonyl group having carbon atoms of 1 to 7, which may have substituent, an arylcarbonyl group having carbon atoms of 5 to 50, which may have substituent, an alkoxycarbonyl group having carbon atoms of 1 to 7, which may have substituent, an aryloxycarbony group having carbon atoms of 5 to 50, which may have substituent, an alkoxycarbonyloxy group having carbon atoms of 1 to 7, which may have substituent, an aryloxycarbonyloxy group having carbon atoms of 5 to 50, which may have substituent, an alkoxycarbonyloxy group having carbon atoms of 5 to 50, which may have substituent, a sulfinyl group, which may have substituent, a sulfonyl group, a sulfanyl group, a silyl group, which may have substituent, a carbamoyl group, which may have substituent, a hydroxy group, a nitro group, a formyl group, a nitroso group, a formyloxy group, an isocyano group, a cyanate group, an isocyanate group, a thiocyanate group, an isothiocyanate group or a cyano group, and neighboring groups thereof may bond each other to form a saturated or unsaturated ring.

3. The organic electroluminescent device according to Claims 1 or 2, wherein the compounds containing amine is the condensed aromatic ring derivatives containing amine represented by the following formula (IV): 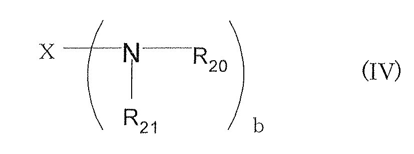 wherein, X represents a condensed aromatic ring group having ring carbon atoms of 10 to 40, which may have substituent, R₂₀ and R₂₁ each independently represents a monovalent aryl group having carbon atoms of 6 to 40, which may have substituent, or a monovalent hetero ring group having carbon atoms of 3 to 40, which may have substituent, and b represents an integer of 1 to 4.

4. The organic electroluminescent device according to Claim 3, wherein X represents a moiety of naphthalene, phenanthrene, fluoranthene, anthracene, pyrene, coronene, chrysene, picene, diphenylanthracene, fluorene, triphenylene, rubicene, benzanthracene, acenaphthofluoranthene, tribenzopentaphene, fluoranthenofluoranthene, benzodifluoranthene, benzofluoranthene or diindenoperylene.

5. The organic electroluminescent device according to Claim 3, wherein the general formula (IV) comprises a compound represented by the following general formula (IV-a): 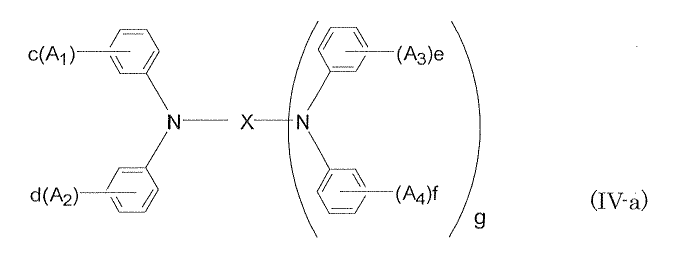 wherein, X represents a condensed aromatic ring group having ring carbon atoms of 10 to 40, which may have substituent, A₁ to A₄ each independently represents a hydrogen atom, an alkyl group having carbon atoms of 1 to 50, which may have substituent, an aryl group having carbon atoms of 5 to 50, which may have substituent, an aralkyl group having carbon atoms of 7 to 50, which may have substituent, a cycloalkyl group having carbon atoms of 3 to 50, which may have substituent, an alkoxyl group having carbon atoms of 1 to 50, which may have substituent, an aryloxyl group having carbon atoms of 5 to 50, which may have substituent, an arylamino group having ring carbon atoms of 5 to 50, which may have substituent, or an alkylamino group having carbon atoms of 1 to 20, which may have substituent;
c, d, e, and f each represents an integer of 0 to 5, g represents an integer of 0 to 4; when c, d, e, and/or f represent 2 or larger, a plural A₁ to A₄ each may be the same with or different from each other, and also may bond each other to form a saturated or unsaturated ring;
however, at least one of A₁ to A₄ represents a sec- or tert-alkyl group having carbon atoms of 3 to 10, which may have substituent.

6. The organic electroluminescent device according to Claim 3, wherein the general formula (IV) comprises a compound represented by the following general formula (IV-a'): 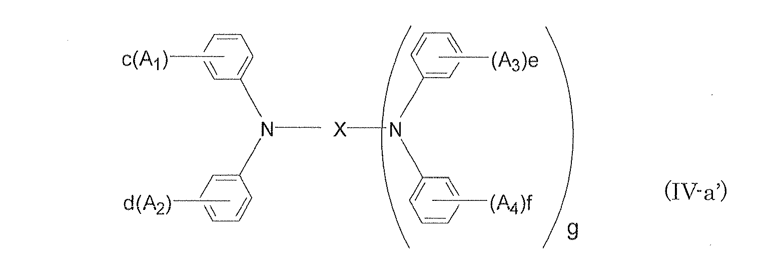 wherein, X represents a condensed aromatic ring group having ring carbon atoms of 10 to 40, which may have substituent, A₁ to A₄ each independently represents a hydrogen atom, an alkyl group having carbon atoms of 1 to 50, which may have substituent, an aryl group having carbon atoms of 5 to 50, which may have substituent, an aralkyl group having carbon atoms of 7 to 50, which may have substituent, a cycloalkyl group having ring carbon atoms of 3 to 50, which may have substituent, an alkoxyl group having carbon atoms of 1 to 50, which may have substituent, an aryloxyl group having carbon atoms of 5 to 50, which may have substituent, an arylamino group having ring carbon atoms of 5 to 50, which may have substituent, or an alkylamino group having carbon atoms of 1 to 20, which may have substituent,
c, d, e, and f each represents an integer of 0 to 5, g represents an integer of 0 to 4,
When c, d, e, and/or f represent 2 or larger, a plural A₁ to A₄ each may be the same with or different from each other, and also may bond each other to form a saturated or unsaturated ring;
however, at least one of c, d, e, and f represents an integer of 2 or larger.

7. The organic electroluminescent device according to Claim 3, wherein the general formula (IV) comprises a compound represented by the following general formula (IV-b): 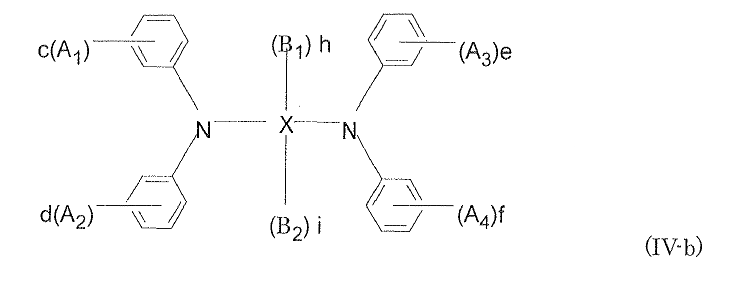 wherein, X represents a condensed aromatic ring group having ring carbon atoms of 10 to 40, A₁ to A₄ each independently represents a hydrogen atom, an alkyl group having carbon atoms of 1 to 50, which may have substituent, an aryl group having carbon atoms of 5 to 50, which may have substituent, an aralkyl group having carbon atoms of 7 to 50, which may have substituent, a cycloalkyl group having ring carbon atoms of 3 to 50, which may have substituent, an alkoxyl group having carbon atoms of 1 to 50, which may have substituent, an aryloxyl group having carbon atoms of 5 to 50, which may have substituent, an arylamino group having carbon atoms of 5 to 50, which may have substituent, or an alkylamino group having carbon atoms of 1 to 20, which may have substituent,
c, d, e, and f each represents an integer of 0 to 5;
when c, d, e, and/or f represent 2 or larger, a plural A₁ to A₄ each may be the same with or different from each other, and also may bond each other to form a saturated or unsaturated ring;
B₁ and B₂ each independently represents a hydrogen atom, an alkyl group having carbon atoms of 1 to 10, which may have substituent, an aryl group having carbon atoms of 6 to 20, which may have substituent, an aralkyl group having carbon atoms of 7 to 50, which may have substituent, a cycloalkyl group having carbon atoms of 3 to 50, which may have substituent, an alkoxyl group having carbon atoms of 1 to 50, which may have substituent, an aryloxyl group having carbon atoms of 5 to 50, which may have substituent; h and i each represents an integer of 0 to 2;
however, at least one of A₁ to A₄ represents a sec- or tert-alkyl group having carbon atoms of 3 to 10, which may have substituent.

8. The organic electroluminescent device according to Claim 3, wherein the general formula (IV) comprises a compound represented by the following general formula (IV-b'): 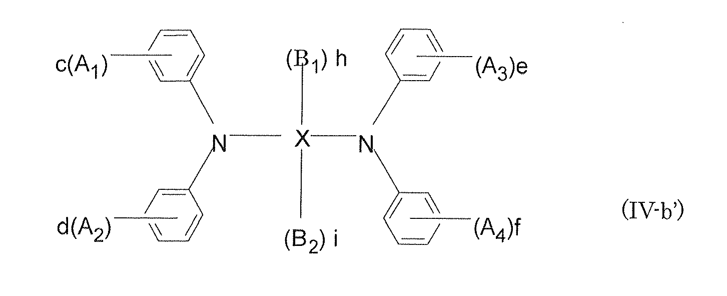 wherein, X represents a condensed aromatic ring group having ring carbon atoms of 10 to 40, A₁ to A₄ each independently represents a hydrogen atom, an alkyl group having carbon atoms of 1 to 50, which may have substituent, an aryl group having carbon atoms of 5 to 50, which may have substituent, an aralkyl group having carbon atoms of 7 to 50, which may have substituent, a cycloalkyl group having ring carbon atoms of 3 to 50, which may have substituent, an alkoxyl group having carbon atoms of 1 to 50, which may have substituent, an aryloxyl group having carbon atoms of 5 to 50, which may have substituent, an arylamino group having carbon atoms of 5 to 50, which may have substituent, or an alkylamino group having carbon atoms of 1 to 20, which may have substituent,
c, d, e, and f each represents an integer of 0 to 5;
when c, d, e, and/or f represent 2 or larger, a plural A₁ to A₄ each may be the same with or different from each other, and also may bond each other to form a saturated or unsaturated ring;
B₁ and B₂ each independently represents a hydrogen atom, an alkyl group having carbon atoms of 1 to 10, which may have substituent, an aryl group having carbon atoms of 6 to 20, which may have substituent, an aralkyl group having carbon atoms of 7 to 50, which may have substituent, an alkoxyl group having carbon atoms of 1 to 50, which may have substituent, an aryloxyl group having carbon atoms of 5 to 50, which may have substituent; h and i each represents an integer of 0 to 2; however, at least one of c, d, e, and f represents an integer of 2 or larger.

9. The organic electroluminescent device according to Claims 1 or 2, wherein the compounds containing amine comprises the styryl derivatives containing amine represented by the following general formula (V): 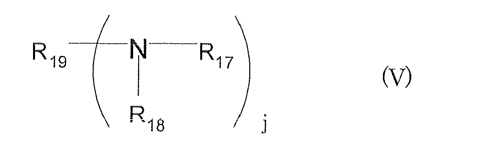 wherein, R₁₇ to R₁₉ each indecently represents a monovalent aryl group having carbon atoms of 6 to 40, which may have substituent, or a monovalent hetero ring group having carbon atoms of 3 to 50, which may have substituent, at least one among them contains a styryl group, j represents an integer of 1 to 4, and the total number of the styryl group is 1 to 4.

10. The organic electroluminescent device according to Claim 1, wherein a host material comprises at least a compound selected from the silacyclopentadiene derivatives represented by the general formula (I) and the boron derivatives represented by the general formula (II), and a dopant comprises at least a compound selected from the compounds containing amine.

11. The organic electroluminescent device according to Claim 2, wherein a host material comprises at least a compound selected from the silacyclopentadiene derivatives represented by the general formula (III), and a dopant comprises at least a compound selected from the compounds containing amine.

12. The organic electroluminescent device according to Claims 1 or 2, wherein the light emitting layer contains 0.01 to 20 % by weight of the compounds containing amine.

13. The organic electroluminescent device according to Claims 1 or 2, comprising at least a layer selected from the group consisting of a chalcogenide layer, a metal halide layer and a metal oxide layer, which is allocated on at least a surface of the pair of the electrodes.

14. The organic electroluminescent device according to Claims 1 or 2, comprising a mixture zone of an organic compound and a reductive dopant, or a mixture zone of an organic compound and an oxidative dopant, which is allocated on at least a surface of the pair of the electrodes.
